# EUROPÄISCHE PATENTANMELDUNG

(11) **EP 4 604 171 A1**
(43) Veröffentlichungstag der Anmeldung: **20.08.2025**
(21) Anmeldenummer: 24220578.9
(22) Anmeldetag: 17.12.2024
(51) Int. Cl.: H01L 21/677

(54) **UMSETZVORRICHTUNG, UMSETZSYSTEM UND VERFAHREN FÜR DEREN BETRIEB**

(30) Priorität: 14.02.2024 DE 102024104153
(71) Anmelder: Werner Lieb GmbH, 96472 Rödental (DE)
(72) Erfinder: BAUER, Maximilian, 96450 Coburg (DE)
(74) Vertreter: Spachmann, Holger

(57) **Zusammenfassung**

Die Erfindung betrifft eine Umsetzvorrichtung (12) zum Umsetzen von Werkstücken und/oder Werkstückträgern zumindest einer verfahrbaren Transportvorrichtung (14) und/oder zumindest einer Fertigungsanlage, wobei die Umsetzvorrichtung (12) dazu ausgebildet ist, in der zumindest einen Transportvorrichtung (14), gelagerte Werkstücke und/oder Werkstückträger zu entladen, und in die zumindest einen Fertigungsanlage weiter zu transportieren, und/oder die zumindest eine Transportvorrichtung (14) mit aus der zumindest einen Fertigungsanlage entnommenen, Werkstücken und/oder Werkstückträgern zu beladen, wobei eine Vorderseite (18) der Umsetzvorrichtung (12) zumindest einen Anschlussport (22) zum temporären Koppeln der Transportvorrichtung (14) umfasst, und eine Rückseite (20) eine an die Fertigungsanalage anschließbare Übergabestelle zur Übergabe von Werkstücken und/oder Werkstückträgern an die Fertigungsanlage umfasst.

Es wird vorgeschlagen, dass der Anschlussport (22) eine Spanneinrichtung (30) zum temporären Koppeln der Transportvorrichtung (14) an den Anschlussport (22) umfasst, die die Transportvorrichtung (14) im gekoppelten Zustand ausgerichtet zentriert, insbesondere in Bezug auf eine Bezugsebene auf welcher die Umsetzvorrichtung (12) angeordnet ist, ausrichtet.

## Beschreibung

Die Erfindung betrifft eine Umsetzvorrichtung zum Umsetzen von Werkstücken und/oder Werkstückträgern zumindest einer verfahrbaren Transportvorrichtung und/oder einer Fertigungsanlage, insbesondere zum Be- und Entladen zwischen zumindest einer Transportvorrichtung und zumindest einer Fertigungsanlage, wobei die Umsetzvorrichtung dazu ausgebildet ist, in der zumindest einen Transportvorrichtung, insbesondere in einem Rollcontainer, gelagerte Werkstücke und/oder Werkstückträger zu entladen, insbesondere zwischenzulagern, und vorzugsweise in die zumindest eine Fertigungsanlage weiter zu transportieren, und/oder die zumindest eine Transportvorrichtung mit, insbesondere in der Umsetzvorrichtung zwischengelagerten, vorzugsweise aus der zumindest einen Fertigungsanlage entnommenen, Werkstücken und/oder Werkstückträgern zu beladen, wobei die Umsetzvorrichtung ein Gehäuse mit einer in eine Umsetzachse ausgerichteten Vorderseite und einer der Vorderseite gegenüberliegenden Rückseite aufweist, wobei die Vorderseite zumindest einen Anschlussport zum temporären Koppeln der zumindest einen Transportvorrichtung umfasst, und die Rückseite eine an die Fertigungsanalage anschließbare Übergabestelle zur Übergabe von Werkstücken und/oder Werkstückträgern an die zumindest eine Fertigungsanlage umfasst.

Weiterhin betrifft die Erfindung ein Umsetzsystem mit einer solchen Umsetzvorrichtung.

Zudem betrifft die Erfindung ein Verfahren zum Betreiben der Umsetzvorrichtung und des Umsetzsystems.

### STAND DER TECHNIK

Umsetzvorrichtungen der eingangs genannten Art sind aus dem Stand der Technik grundsätzlich bekannt, beispielsweise aus der DE 10 2004 058 108 B4, der DE 10 2019 217 003 B4 und der DE 10 2011 100 082 A1.

Eine solche Umsetzvorrichtung ist üblicherweise Teil eines Umsetzsystems, welches neben der Umsetzvorrichtung in der Regel zumindest eine Transportvorrichtung, meistens auch eine zuordenbare Fertigungsanlage umfasst. Die Umsetzvorrichtung dient in der Regel dazu, in der Transportvorrichtung, z.B. ein verfahrbarer Transportcontainer oder eine Lagerbox, gelagerte Werkstücke und/oder Werkstückträger, die eines oder mehrere Werkstücke, z.B. Elektronikbauteile, Baugruppen, Substrate der Halbleiterproduktion wie Wafer oder PCBs aufnehmen, aus der Transportvorrichtung zu entnehmen und an die nachgeschaltete Fertigungsanlage zu übergeben. Die Fertigungsanlage kann zur prozesstechnischen Behandlung der Werkstücke oder Werkstückträger eingerichtet sein, und, als nicht abschließende Aufzählung beispielsweise als Löt-, Sinter-, Sputter- oder Einhausungsanlage eingerichtet sein.

Zusätzlich ist die Umsetzvorrichtung oftmals dazu ausgebildet, die Transportvorrichtung mit den Werkstücken und/oder Werkstückträgern zu beladen, beispielsweise indem diese von einer anderen Transportvorrichtung überführt werden, indem die Werkstücke und/oder Werkstückträger vorab aus der einen Transportvorrichtung entnommen und bis zum Beladen in der Umsetzvorrichtung zwischengelagert wurden. Hierfür weist die Umsetzvorrichtung regelmäßig einen Anschlussport, an welchem die Transportvorrichtung ankoppelbar ist, sowie eine Übergabestelle, an welche die Fertigungsanlage anschließbar ist, auf. Mittels Anschlussport und Übergabestelle ist seitens der Umsetzvorrichtung der Zugriff auf die Werkstücke und/oder Werkstückträger und damit deren Handhabung im Rahmen des Umsetzprozesses ermöglicht.

Bei dem vorstehend erörterten Umsetzsystem besteht ein Bedarf an Automatisierungsmöglichkeiten, insbesondere hinsichtlich einer Beschleunigung des Umsetzprozesses und Senkung der Betriebskosten, sodass die Effizienz der Prozesskette gesteigert werden kann. Aktuelle Umsetzsysteme weisen daher einen hohen Automatisierungsgrad auf, der bis zu einer vollständigen Automatisierung, also im Wesentlichen ohne menschliches Bedienpersonal, reichen kann.

Für einen problemlosen Prozessablauf ist bei derartig hoch automatisierten Prozessketten eine Sicherstellung der einwandfreien Funktionalität aller Komponenten essenziell. Es muss daher sichergestellt werden, dass die einzelnen Prozessschritte, insbesondere das Ankoppeln der Transportvorrichtung und das Handhaben der Werkstücke und/oder Werkstückträger fehlerfrei abläuft bzw. eine geringe Fehleranfälligkeit aufweist. Nur dann kann ein reibungsfreier Prozessablauf gewährleistet werden, der eine hohe Produktivität aufweist und kein Eingreifen von menschlichem Bedienpersonal erfordert. Allerdings kommt es gerade bei dem Prozessschritt des Ankoppelns der Transportvorrichtung an die Umsetzvorrichtung und dem anschließend geplanten Entnehmen der Werkstücke und/oder Werkstückträger bei bekannten Systemen oftmals zu Problemen. Denn insbesondere in Abhängigkeit der Standortverhältnisse der Umsetzvorrichtung, beispielsweise Unebenheiten im Boden, kann das Ankoppeln nicht richtig bzw. unpräzise erfolgen, da ein automatisiertes korrektes Andocken durch einen schiefen Boden, falsche Ausrichtung o.Ä. nicht oder nur erschwert stattfindet. In der Folge dauert der Prozessschritt länger oder es ist sogar eine Nachjustierung durch Bedienpersonal erforderlich. Auch wird insbesondere dann, wenn die Transportvorrichtung nicht richtig, insbesondere schief ausgerichtet angekoppelt ist, die Entnahme der Werkstücke und/oder Werkstückträger deutlich erschwert bzw. behindert. Effizienz und reibungsloser Ablauf der Prozesskette werden somit erheblich negativ beeinträchtigt. Insofern besteht ein erhöhter Bedarf an Lösungen, die automatisiert ein fehlerfreies Ankoppeln dauerhaft ermöglicht.

Die Aufgabe der Erfindung ist es, eine gegenüber der vorstehend erörterten Problematik verbesserte Lösung bereitzustellen, die insbesondere eine zuverlässige Zentriermöglichkeit zur Korrektur einer fehlerhaften Ausrichtung der Transportvorrichtung ermöglicht.

Diese Aufgabe wird durch eine Umsetzvorrichtung, ein Umsetzsystem und ein Verfahren nach den unabhängigen Ansprüchen gelöst. Vorteilhafte Ausbildungen der Erfindung sind Gegenstand der Unteransprüche.

### OFFENBARUNG DER ERFINDUNG

Die Erfindung geht aus von einer Umsetzvorrichtung zum Umsetzen von Werkstücken und/oder Werkstückträgern zumindest einer verfahrbaren Transportvorrichtung und/oder zumindest einer Fertigungsanlage, insbesondere zum Be- und Entladen zwischen zumindest einer Transportvorrichtung und zumindest einer Fertigungsanlage, wobei die Umsetzvorrichtung dazu ausgebildet ist, in der zumindest einen Transportvorrichtung, insbesondere in einem Rollcontainer, gelagerte Werkstücke und/oder Werkstückträger zu entladen, insbesondere zwischenzulagern, und vorzugsweise in die zumindest eine Fertigungsanlage weiter zu transportieren, und/oder die zumindest eine Transportvorrichtung mit, insbesondere in der Umsetzvorrichtung zwischengelagerten, vorzugsweise aus der zumindest einen Fertigungsanlage entnommenen, Werkstücken und/oder Werkstückträgern zu beladen, wobei die Umsetzvorrichtung ein Gehäuse mit einer in eine Umsetzachse ausgerichteten Vorderseite und einer der Vorderseite gegenüberliegenden Rückseite aufweist, wobei die Vorderseite zumindest einen Anschlussport zum temporären Koppeln der zumindest einen Transportvorrichtung umfasst, und die Rückseite eine an die Fertigungsanalage anschließbare Übergabestelle zur Übergabe von Werkstücken und/oder Werkstückträgern an die zumindest eine Fertigungsanlage umfasst.

Unter dem Begriff Umsetzen ist im Zusammenhang mit der vorliegenden Erfindung unter anderem ein Zugriff auf die (in der Transportvorrichtung gelagerten) Werkstücke und/oder Werkstückträger über den Anschlussport, insbesondere mittels einer Handhabungseinrichtung, und eine Ausgabe der zuvor gegriffenen Werkstücke und/oder Werkstückträger aus der Übergabestelle sowie darauffolgende Übergabe an die Fertigungsanlage zu verstehen, also insgesamt eine Prozesskette beginnend bei der Entnahme der Werkstücke und/oder Werkstückträger aus der Transportvorrichtung und endend mit deren Abgabe an die Fertigungsanlage. Gleichwohl ist ein Umsetzen auch als rückwärtiger Verlagerungsvorgang von der Fertigungsanlage hin zur Transportvorrichtung, aber auch ein paralleler Verlagerungsvorgang zwischen benachbarten Transportvorrichtungen bzw. benachbarten Fertigungsanlagen zu verstehen.

Die Umsetzachse stellt eine generelle Übergaberichtung dar, bevorzugt innerhalb einer waagrechten Ebene.

Unter dem Begriff Koppeln ist im Zusammenhang mit der vorliegenden Erfindung ein steuerbares sowie lösbares und wahlweise temporäres funktionales Verbinden zweier Elemente, beispielsweise Transportvorrichtung und Anschlussport, zu verstehen. Das Koppeln umfasst insbesondere ein Anordnen der beiden Elemente beieinander sowie deren physisches Verbinden.

Der Anschlussport und die Übergabestelle sind insofern vorliegend der Transportvorrichtung bzw. der Fertigungsanlage zugeordnet bzw. zuordenbar.

Erfindungsgemäß ist vorgesehen, dass der Anschlussport eine Spanneinrichtung für die Transportvorrichtung aufweist, die ausgebildet ist, die Transportvorrichtung zum temporären Koppeln an den Anschlussport, bevorzugt automatisiert, an dem Anschlussport lösbar zu arretieren sowie im gekoppelten Zustand ausgerichtet zu zentrieren, insbesondere in Bezug auf eine Bezugsebene, insbesondere Bodenfläche, auf welcher die Umsetzvorrichtung angeordnet ist, auszurichten.

Die erfindungsgemäße Lösung ermöglicht somit beim Koppeln eine automatisierte Arretierung in Verbindung mit einer gleichzeitig erfolgenden ausrichtenden Zentrierung der Transportvorrichtung gegenüber dem Anschlussport. Ausgerichtete Zentrierung bedeutet in diesem Zusammenhang, dass die gekoppelte Transportvorrichtung gezielt in eine vorgerichtete Position verbracht wird, in welcher die Werkstücke und/oder Werkstückträger optimal handhabbar sind, sodass der Umsetzvorgang im Wesentlichen störungsfrei bzw. unproblematisch automatisiert durchführbar ist. Vorteilhafterweise wird hierdurch der Umsetzprozess deutlich vereinfacht und hinsichtlich einer Effizienz gesteigert.

Die erfindungsgemäße Umsetzvorrichtung dient somit zur automatisierten Umsetzung in Form einer Schnittstelle zwischen der Transportvorrichtung und der Fertigungsanlage. In ihr kann ein flexibles Handling der Werkstücke bzw. der Werkstückträger bei hohem Durchsatz und verringerter Fehleranfälligkeit erreicht werden.

Regelmäßig kann ein Durchgriffsbereich des Anschlussports mittels einer Sicherheitseinrichtung, beispielsweise einer Zugangssicherung wie eine, vorzugsweise automatisch bewegbare, Sicherheitstür, Sicherheitsjalousie oder ähnliches gesichert sein. Dies erhöht eine Betriebssicherheit für Personal und kann vor einer Fehlbeschickung einer Fertigungsanlage schützen. Die Sicherheitseinrichtung kann bereits bei einem Annähern einer Transportvorrichtung den Durchgriffsbereich des Anschlussports öffnen, oder vorzugsweise erst nach Abschluss eines erfolgreichen Ankoppelns und Ausrichten und korrekter Identifikation einer erwarteten Transportvorrichtung an den Anschlussport öffnen oder öffenbar sein. Durch eine Sicherheitseinrichtung kann ein Personenschutz erhöht, sowie eine Fehlbeladung oder Schäden durch fehlerhafte Kopplung und Ausrichtung verhindert werden.

Eine Transportvorrichtung kann ggf. mit einer inneren Elektronik ausgestattet sein, die bei erfolgreichem Ankoppeln mit einer elektrischen Schnittstelle und Betriebsstromversorgung der Umsetzvorrichtung verbunden werden kann. Ein erfolgreiches Ankoppeln kann eine korrekte Identifikation der Transportvorrichtung sowie ein erfolgreicher Kopplungs- und Ausrichtungszustand voraussetzen. Dies kann beispielsweise unter der Bedingung erfolgen, dass die Transportvorrichtung von der Umsetzvorrichtung als erwartet und richtig identifiziert wurde. Auch kann, insbesondere zum Einhalten von ESD-Standards und zur Sicherstellung einer konformen elektrischen Erdung eine Erdungsverbindung mit einem Erdungs- oder Potentialausgleichsanschluss der Umsetzvorrichtung hergestellt werden. Dies erhöht die elektrische Sicherheit und kann bei empfindlichen elektronischen Bauteilen eine Notwendigkeit der weiteren Bearbeitung darstellen. Die elektrische Verbindung bzw. Potentialausgleich bzw. Erdung kann bei Kopplung der Transportvorrichtung mit dem Anschlussport automatisch bzw. zwangsgeführt bereitgestellt werden.

Gemäß einer bevorzugten Weiterbildung ist vorgesehen, dass die Spanneinrichtung eine Rasteinheit mit zumindest einem, vorzugsweise zumindest zwei, federgelagerten Rasthacken sowie eine hydraulische und/oder pneumatische Spanneinheit umfasst, wobei die Rasteinheit dazu ausgebildet ist, durch Einrasten der Transportvorrichtung diese an dem Anschlussport lösbar zu arretieren, und wobei die Spanneinheit dazu ausgebildet ist, die arretierte Transportvorrichtung durch Verspannen in dem Anschlussport ausgerichtet zu zentrieren. Vorteilhafterweise wird mit den federgelagerten Rasthacken und der Spanneinheit eine einfach konstruierbare, mechanischfehlerrobuste und damit kostengünstige und wenig wartungsintensive Lösung zur Arretierung und Zentrierung der Transportvorrichtung bereitgestellt. Das Verspannen hat hierbei den weiteren Vorteil, dass die Zentrierung besonders unkompliziert erfolgt und gleichzeitig eine zusätzliche mechanische Sicherung bzw. Arretierungsmöglichkeit ermöglicht ist.

Gemäß einer bevorzugten Weiterbildung ist vorgesehen, dass die Spanneinheit zumindest einen Spannzylinder und eine dem Spannzylinder zugeordnete Gegendruckfläche umfasst, wobei der Spannzylinder aus einem ersten Flankenbereich des Anschlussports in Richtung eines dem ersten Flankenbereich gegenüberliegenden zweiten Flankenbereich, in welchem die Gegendruckfläche ausgebildet ist, ausfahrbar ist, sodass die arretierte Transportvorrichtung durch Ausfahren des Spannzylinders in Richtung der Gegendruckfläche einspannbar und ausgerichtet zentrierbar ist. Vorteilhafterweise weist die Spanneinheit dadurch ein besonders einfach konstruierbares Funktionsprinzip bzw. eine hohe mechanische Robustheit auf, sodass die Herstellungskosten und Fehleranfälligkeit weiter gesenkt werden.

Gemäß einer bevorzugten Weiterbildung ist vorgesehen, dass die Umsetzvorrichtung eine im Inneren des Gehäuses angeordnete Handhabungseinrichtung zum Handhaben der Werkstücke und/oder Werkstückträger aufweist, wobei die Handhabungseinrichtung zumindest eine Fördereinheit zum Fördern der Werkstücke und/oder Werkstückträger in die Umsetzachse aufweist. Die Handhabungseinrichtung dient dazu, die Werkstücke und/oder Werkstückträger im Rahmen des Umsetzprozess zu handhaben bzw. ermöglicht den Umsetzprozess. Handhaben umfasst ein generelles Bewegen der Werkstücke und/oder Werkstückträger von einer Ausgangsposition in zumindest eine Endposition. Insbesondere umfasst das Handhaben ein Fördern der Werkstücke und/oder Werkstückträger, eine Entnahme der Werkstücke und/oder Werkstückträger aus der Transportvorrichtung, ein Beladen der Transportvorrichtung mit in der Umsetzvorrichtung zwischengelagerten Werkstücken, und/oder ein Befördern der Werkstücke und/oder Werkstückträger aus der Transportvorrichtung und/oder Umsetzvorrichtung in die Fertigungstransportvorrichtung oder der Fertigungsanalage.

Die Handhabungseinrichtung ist in diesem Zusammenhang sowohl dem Anschlussport, als auch der Übergabestelle zuordenbar bzw. zugeordnet. Die Fördereinheit als Teil der Handhabungseinrichtung wiederum dient im Wesentlichen zum expliziten Fördern der Werkstücke und/oder Werkstückträger. Entnahme, Beladen und Befördern der Werkstücke und/oder Werkstückträger wird im Wesentlichen von der Fördereinheit durchgeführt. Insbesondere kann die Handhabungseinrichtung zumindest eine, insbesondere mehrere Fördereinheiten aufweisen. Vorteilhafterweise ermöglicht die Handhabungseinrichtung ein vollumfängliches, flexibles, effizientes und automatisiertes bzw. automatisierbares Handhaben der Werkstücke und/oder Werkstückträger.

Gemäß einer bevorzugten Weiterbildung ist vorgesehen, dass eine Spurbreite der Fördereinheit in einer horizontalen Verlagerachse in Bezug auf eine Größe oder einen Durchmesser der zu fördernden Werkstücke und/oder Werkstückträger, insbesondere automatisiert, anpassbar ist.

Die Spurbreite stellt im Wesentlichen die Breite einer Lagerfläche für die Werkstücke und/oder Werkstückträger im Rahmen des Förder- bzw. Handhabungsprozesses dar, welche sich in einer die Verlagerachse aufweisenden horizontalen Ebene befindet. Die Anpassbarkeit der Spurbreite ermöglicht vorteilhafterweise ein Handhaben bzw. Umsetzen verschiedener Größen von Werkstücken und/oder Werkstückträgern, sodass eine besonders vorteilhafte Flexibilität hinsichtlich der potentiell umsetzbaren Werkstücke und/oder Werkstückträger bereitgestellt ist.

Gemäß einer bevorzugten Weiterbildung ist vorgesehen, dass die Spurbreite durch Verlagern von zumindest einem, insbesondere zwei, eine Förderspur entlang der Umsetzachse bildende, und parallel zueinander verlaufenden Führungsblechen der Fördereinheit anpassbar ist, wobei vorzugsweise die Führungsbleche durch einen Antriebsmotor verlagerbar sind, der mittels eines Getriebes, insbesondere Gewindespindeln, derart mit den Führungsblechen gekoppelt ist, dass diese synchron aufeinander zu oder voneinander weg verlagerbar sind. Die Förderspur weist hierdurch eine anpassbare Spurbreite auf. Vorteilhafterweise ist hiermit eine mechanisch simple Konstruktion der Fördereinheit bereitgestellt, die aufgrund der Simplizität eine hohe Robustheit und Fehlertoleranz aufweist. Zudem erfolgt bei dieser Konstruktion die Anpassung der Spurbreite durch synchrones Verlagern der Führungsbleche, sodass die Anpassung besonders schnell erfolgen kann und damit die generelle Effizienz der Umsetzvorrichtung auf vorteilhafte Weise weiter gesteigert wird.

Gemäß einer bevorzugten Weiterbildung ist vorgesehen, dass die Handhabungseinrichtung dazu ausgebildet ist, die Fördereinheit zumindest entlang einer horizontalen und/oder vertikalen Verlagerachse orthogonal zur Umsetzachse zu verlagern, und/oder zu handhabende Werkstücke und/oder Werkstückträger und/oder die Fördereinheit um zumindest eine Verlagerachse und/oder um die Umsetzachse, vorzugsweise dreidimensional, rotatorisch auszurichten. In anderen Worten ist die Handhabungseinrichtung dazu ausgebildet, die Werkstücke und/oder Werkstückträger im Wesentlichen in jede beliebige Raumrichtung zu verlagern bzw. auszurichten. Insbesondere ist dadurch eine Überkopfausrichtung ermöglicht. Vorteilhafterweise werden dadurch die Flexibilität im Rahmen des Umsetzprozesses weiter erhöht und dessen Effizienz sowie die potenziellen Einsatzmöglichkeiten der Umsetzvorrichtung nochmals gesteigert.

Gemäß einer bevorzugten Weiterbildung ist vorgesehen, dass die Umsetzvorrichtung, vorzugsweise die Handhabungseinrichtung, zumindest eine Identifikationseinrichtung zur automatisierten Identifikation der Transportvorrichtung und/oder der Werkstücke und/oder der Werkstückträger, und/oder zur automatisierten Ermittlung einer Belegung der Transportvorrichtung mit Werkstücken und/oder Werkstückträgern aufweist. Beispielsweise kann die Identifikationseinrichtung zumindest eine Kamera, Steuereinheit, und/oder Scanner o. Ä. aufweisen, die insbesondere in Verbindung mit einem korrespondierenden Barcode, QR-Code, DMC-Code (Data Matrix Code), RFID-Tag usw., welche bevorzugt an Transportvorrichtung/Werkstücken/Werkstückträgern angeordnet bzw. diesen zugeordnet sind, eine automatisierte, bevorzugt optische oder funkbasierte Identifikation ermöglichen. Die Identifikationseinrichtung hat den Vorteil, dass automatisiert die konkret zu handhabende Transportvorrichtung bzw. die Werkstücke/Werkstückträger identifiziert werden können und in Abhängigkeit davon der Umsetzprozess, insbesondere in Bezug auf die Ansteuerung der Handhabungseinrichtung und/oder der Anpassung der Spurbreite der Fördereinheit, flexibel anpassbar bzw. darauf optimierbar ist, sodass dessen Effizienz und Geschwindigkeit weiter gesteigert werden können. Durch den Einsatz zumindest einer Identifikationseinrichtung wird eine heterogene Beladung einer Transportvorrichtung mit verschiedenartigen Werkstückträger, bzw. auf einem Werkstückträger heterogenen Werkstücken ermöglicht. Da die Werkstücke auf einem Werkstückträger identifizierbar sind, können auf bzw. in einem Werkstückträger bzw. in einer Transportvorrichtung verschiedenartige Werkstücke angeordnet sein, die individuell erkennbar sind. Da Werkstückträger identifizierbar sind, können verschiedenartige Werkstückträger in einer Transportvorrichtung angeordnet sein, die von der Umsetzvorrichtung erkennbar sind. Dies ermöglicht eine Identifikation und Zuordnung eines spezifischen Werkstücks mit einem Werkstückträger bzw. mit einer Transportvorrichtung, und eines Werkstückträgers mit den darin umfassten Werkstücken und der Transportvorrichtung, und der Transportvorrichtung mit den darin umfassten Werkstücken und Werkstückträgern. Dies ermöglicht eine Rückverfolgbarkeit und Assoziation von Werkstücken, Werkstückträgern und Transportvorrichtungen.

Vorteilhaft kann zumindest eine erste Identifikationseinrichtung vorgesehen sein, die eine Identifikation der Transportvorrichtung vornimmt. Die Identifikation der Transportvorrichtung kann vor, während oder nach einem Ankoppeln an den Anschlussport erfolgen. Da in der Regel die Umsetzvorrichtung eine Information über eine zu erwartenden Transportvorrichtung und insbesondere über den Inhalt der darin befindlichen Werkstücke und/oder Werkstückträger hat, kann im Falle einer als falsch identifizierten Transportvorrichtung eine Sicherheitseinrichtung einen Zugang zu einem Durchgriffsbereichs des Anschlussports verschlossen halten, so dass die Sicherheitseinrichtung nicht geöffnet werden, so dass ein Zugang durch den Anschlussport verschlossen bleibt, oder ein Koppelvorgang nicht begonnen wird, abgebrochen wird, oder wieder entkoppelt wird. Hierbei kann eine weitere, zweite Identifikationseirichtung vorgesehen sein, die bei geöffnetem Anschlussport gelagerte Werkstückträger und/oder Werkstücke im Inneren der Transportvorrichtung identifiziert. Dazu kann weiterhin vorteilhaft eine dritte Identifikationseinrichtung vorgesehen sein, die die Werkstücke identifiziert, während die zweite Identifikationseinrichtung die Warenträger identifiziert. Insoweit können in einer Ausführungsform zumindest zwei, bevorzugt drei Identifikationseinrichtungen oder Gruppen von zwei bzw. Identifikationseinrichtungen für eine Identifikation der Transportvorrichtung, der Werkstückträger und der Werkstücke separat vorgesehen sein.

Gemäß einer bevorzugten Weiterbildung ist vorgesehen, dass die zumindest eine Identifikationseinrichtung eine entlang zumindest einer Verlagerachse, insbesondere rasterförmig, verfahrbare Sensoreinheit aufweist, die dazu ausgebildet ist, im gekoppelten Zustand der Transportvorrichtung eine Belegung der Transportvorrichtung mit Werkstücken und/oder Werkstückträgern zu ermitteln, und/oder in der Transportvorrichtung gelagerte Werkstücke und/oder Werkstückträger zu identifizieren. In anderen Worten prüft die Identifikationseinrichtung mittels eines rasterförmigen Scannens in Spalten und Zeilen durch die Sensoreinheit, vorzugsweise bei beibehaltener Lagerposition der Werkstücke bzw. Werkstückträger in der Transportvorrichtung, ob und wenn ja auf welche Weise die aktuell gekoppelte Transportvorrichtung mit Werkstücken und/oder Werkstückträgern belegt ist. In Abhängigkeit davon kann vorteilhafterweise der darauffolgende Umsetzprozess, insbesondere die Ansteuerung und Einstellung der Handhabungseinrichtung, optimal angepasst werden, um einen schnellen und effizienten Umsetzprozess zu gewährleisten.

Gemäß einer bevorzugten Weiterbildung ist vorgesehen, dass die Identifikationseinrichtung eine Identifikationseinheit, insbesondere Kamera, Code-Scanner und/oder (Funk-)Transponder, aufweist, welche dazu ausgebildet ist, die Transportvorrichtung, insbesondere im gekoppelten Zustand, zu identifizieren, insbesondere anhand eines zu der Identifikationseinheit komplementären optischen oder funkbasierten Identifikationsmittels, insbesondere DMC-Code, QR-Code, RFID/NFC-Tag oder dergleichen. Vorteilhafterweise ist hierdurch auf simple und somit kostengünstige Weise eine sichere und zuverlässige Identifikation ermöglicht.

Durch die individuelle Identifikation sowohl der Transportvorrichtung, als auch der Werkstückträger und der Werkzeuge kann eine rückverfolgbare Datenstruktur der Zuordnung von Werkstücken zu Werkstückträger und diese zu Transportvorrichtungen bereitgestellt werden, die beispielsweise mit erwarteten Zuordnungen verglichen werden, um eine Konsistenzprüfung der Richtigkeit der angelieferten Werkstücke, der Werkzeugträgerbelegung und Transportvorrichtung durchzuführen. Auch kann beispielsweise bei Erkennen eines fehlerhaften Fertigungsvorgangs an einem Werkstück nicht nur das einzelne Werkstück als fehlerhaft identifizierte werden, sondern auch die dazu auf demselben Werkstückträger angeordneten und parallel gefertigten Werkstücke oder die gesamte Beladung einer dazugehörigen Transportvorrichtung nachverfolgt und einer gesonderten Qualitätskontrolle zugeführt werden.

Gemäß einer bevorzugten Weiterbildung ist vorgesehen, dass die Umsetzvorrichtung an der Vorderseite zwei oder mehrere nebeneinander angeordnete Anschlussports für jeweils eine weitere Transportvorrichtung aufweist. Die Umsetzvorrichtung kann vorteilhafterweise mehrere Transportvorrichtungen ankoppeln, um ein sequenzielles oder gleichzeitiges Be- und Entladen bzw. Werkstücke und/oder Werkstückträger aus mehreren Transportvorrichtungen gleichzeitig oder zumindest unmittelbar aufeinanderfolgend zu ermöglichen. Insofern weist jeder Anschlussport jeweils eine eigene Spanneinrichtung auf. Insbesondere weist die Umsetzvorrichtung zumindest eine Handhabungseinrichtung auf, die gleichzeitig mehreren Anschlussports zugeiordnet ist. Alternativ kann auch vorgesehen sein, dass jeder Anschlussport eine eigene Handhabungseinrichtung aufweist bzw. jedem Anschlussport eine konkrete Handhabungseinrichtung zugeordnet ist. Vorteilhafterweise werden die Einsatzmöglichkeiten der Umsetzvorrichtung dadurch weiter gesteigert.

Gemäß einer bevorzugten Weiterbildung ist vorgesehen, dass die Umsetzvorrichtung an der Rückseite zwei oder mehrere nebeneinander angeordnete Übergabestellen zur Übergabe von Werkstücken und/oder Werkstückträgern an zwei oder mehrere Fertigungsanlagen aufweist. Jede Übergabestelle ist bevorzugt an jeweils eine Fertigungsanlage anschließbar. Optional können zusätzlich oder alternativ, aber auch analog zu den Anschlussports zwei oder mehr Übergabestellen an die gleiche Fertigungsanalage anschließbar sein oder eine Übergabestelle an mehrere Fertigungsanalagen. Auch kann die Umsetzvorrichtung optional Werkstücke und/oder Werkstückträger zentral aufnehmen und an zwei oder mehrere Fertigungsanlagen übergeben, sodass sie im Wesentlichen als zentraler Loadinghub für parallel angeordnete Fertigungsanlagen, die identisch oder unterschiedlich ausgeführt sein können, dient. Vorteilhafterweise werden die Einsatzmöglichkeiten der Umsetzvorrichtung dadurch weiter gesteigert.

Gemäß einer bevorzugten Weiterbildung ist vorgesehen, dass die Umsetzvorrichtung dazu ausgebildet ist, Werkstücke und/oder Werkstückträger, die in einer an einem ersten Anschlussport angeschlossenen ersten Transportvorrichtung gelagert sind, in eine zweite Transportvorrichtung, die an einem zweiten Anschlussport angeschlossen ist, automatisiert direkt oder mittelbar umzusetzen, und/oder dass die Umsetzvorrichtung dazu ausgebildet ist, Werkstücke und/oder Werkstückträger, die einer, an einer ersten Übergabestelle angeschlossenen, ersten Fertigungsanlage entnehmbar sind, an eine, an einer zweiten Übergabestelle angeschlossenen, zweiten Fertigungsanlage, automatisiert direkt oder mittelbar zu übergeben.

Ein direktes Umsetzen bedeutet in diesem Zusammenhang, dass keine Zwischenlagerung in der Transportvorrichtung oder Fertigungsanlage erfolgt, im Falle eines mittelbaren Umsetzens hingegen schon. Vorteilhafterweise ist die Umsetzvorrichtung dadurch besonders vielseitig einsetzbar.

Gemäß einer bevorzugten Weiterbildung ist vorgesehen, dass die Umsetzvorrichtung eine, insbesondere in dem Gehäuse angeordnete, Steuereinheit aufweist, die dazu ausgebildet ist, die Umsetzvorrichtung zumindest zum automatisierten Be- und Entladen der Transportvorrichtung mit Werkstücken und/oder Werkstückträgern sowie zum automatisierten Umsetzen der Werkstücke und/oder Werkstückträger von der Transportvorrichtung oder aus der Umsetzvorrichtung in die die Fertigungsanalage und umgekehrt zu steuern, wobei die Steuereinheit vorzugsweise eine Schnittstelle zur Kommunikation mit einer Steuereinheit der Fertigungsanlage aufweist, insbesondere eine Industriebus-Kommunikationsschnittstelle aufweist. Die Steuereinheit stellt einen zentralen Knotenpunkt für den automatisierten Betrieb bzw. Einsatz der Umsetzvorrichtung dar. Vorteilhafterweise ist die Umsetzvorrichtung dadurch vielseitig einsetzbar und weist einen hohen potentiellen Automatisierungsgrad auf.

Die Erfindung betrifft in einem Nebenaspekt ein Umsetzsystem zum Be- und Entladen sowie Umsetzen von Werkstücken und/oder Werkstückträgern, zumindest aufweisend zumindest eine verfahrbare Transportvorrichtung zum temporären Lagern und Transportieren von Werkstücken und/oder Werkstückträgern, zumindest eine Fertigungsanalage zum Weiterverarbeiten der Werkstücke und/oder Werkstückträger in einem Fertigungsprozess, und zumindest eine Umsetzvorrichtung zum Umsetzen von Werkstücken und/oder Werkstückträgern der Transportvorrichtung und/oder der Fertigungsanlage, insbesondere zum Be- und Entladen sowie Umsetzen zwischen Transportvorrichtung und Fertigungsanlage.

Das Umsetzsystem zeichnet sich erfinderisch dadurch aus, dass die Umsetzvorrichtung erfindungsgemäß, wie im Vorfeld beschrieben, ausgebildet ist. Es ergeben sich die diesbezüglich im Vorfeld bereits genannten Vorteile.

Die Erfindung betrifft in einem weiteren Nebenaspekt ein Verfahren zum Betreiben einer Umsetzvorrichtung, insbesondere der erfindungsgemäßen Umsetzvorrichtung, und/oder eines Umsetzsystems, insbesondere des erfindungsgemäßen Umsetzsystems, wobei Werkstücke und/oder Werkstückträger zumindest einer verfahrbaren Transportvorrichtung und/oder zumindest einer Fertigungsanlage umgesetzt werden, insbesondere zwischen Transportvorrichtung und Fertigungsanlage Be- und Entladen sowie umgesetzt werden.

Erfindungsgemäß ist vorgesehen, dass die Transportvorrichtung zum temporären Koppeln an einen Anschlussport der Umsetzvorrichtung durch eine Spanneinrichtung der Umsetzvorrichtung, bevorzugt automatisiert, lösbar an dem Anschlussport arretiert und im angeschlossenen Zustand durch die Spanneinrichtung ausgerichtet zentriert wird, insbesondere in Bezug auf eine Bezugsebene, insbesondere Bodenfläche, auf welcher die Umsetzvorrichtung angeordnet ist, ausgerichtet wird. Es ergeben sich die diesbezüglich im Vorfeld bereits genannten Vorteile.

Gemäß einer bevorzugten Weiterbildung ist vorgesehen, dass die Transportvorrichtung durch eine Rasteinheit der Spanneinrichtung lösbar an dem Anschlussport arretiert wird und im arretierten Zustand durch eine hydraulische und/oder pneumatische Spanneinheit der Spanneinrichtung durch Verspannen in dem Anschlussport ausgerichtet zentriert wird, vorzugsweise indem ein Spannzylinder der Spanneinheit in Richtung eines einem ersten Flankenbereich des Anschlussports gegenüberliegenden zweiten Flankenbereich, in welchem eine Gegendruckfläche für den Spannzylinder ausgebildet ist, ausgefahren wird, sodass die arretierte Transportvorrichtung durch Ausfahren des Spannzylinders in Richtung der Gegendruckfläche eingespannt und ausgerichtet zentriert wird. Alternativ oder zusätzlich kann eine Sicherheitseinrichtung einen Zugang eines Anschlussports basierend auf der Identifikation der Transportvorrichtung bereitstellen. Durch eine Identifikation einer zu erwarteten Transportvorrichtung und/oder einem korrekten Kopplungszustand kann eine Sicherheitseinrichtung wie z.B. eine Sicherheitstür oder Sicherheitsjalousie am oder im Anschlussport geöffnet werden, um einen Durchgriff durch den Anschlussport zum Be- oder Entladen der Transportvorrichtung zu ermöglichen. Somit kann insbesondere ein Personenschutz erhöht und ein Schutz gegen Fehlbeladung oder Schäden bei inkorrekter Kopplung und Ausrichtung erreicht werden.

Gemäß einer bevorzugten Weiterbildung ist vorgesehen, dass das Umsetzen der Werkstücke und/oder Werkstückträger durch eine Handhabungseinrichtung, die eine Fördereinheit zum Fördern der Werkstücke und/oder Werkstückträger in Richtung einer Umsetzachse aufweist, gehandhabt werden, wobei eine Spurbreite der Fördereinheit in Bezug auf eine Größe oder einen Durchmesser der zu handhabenden Werkstücke und/oder Werkstückträger, bevorzugt automatisiert, angepasst wird, wobei vorzugsweise zur Anpassung der Spurbreite zumindest zwei, die Spur bildendende und parallel zueinander verlaufende, Führungsbleche der Fördereinheit durch einen Antriebsmotor verlagert werden. Es ergeben sich die diesbezüglich im Vorfeld bereits genannten Vorteile.

Gemäß einer bevorzugten Weiterbildung ist vorgesehen, dass durch eine Identifikationseinrichtung der Umsetzvorrichtung die Transportvorrichtung und/oder Werkstücke und/oder Werkstückträger automatisiert identifiziert und/oder eine Belegung der Transportvorrichtung mit Werkstücken und/oder Werkstückträgern automatisiert ermittelt wird, wobei vorzugsweise
- im angeschlossenen Zustand der Transportvorrichtung die Ermittlung der Belegung der Transportvorrichtung mit Werkstücken und/oder Werkstückträgern und/oder die Identifikation der in der Transportvorrichtung gelagerten Werkstücke und/oder Werkstückträger durch eine entlang zumindest einer Verlagerachse, insbesondere rasterförmig, verfahrbare Sensoreinheit erfolgt,
- und/oder die Identifikation der Transportvorrichtung durch eine Identifikationseinheit, insbesondere Kamera, Code-Scanner und/oder Transponder, erfolgt, insbesondere anhand eines zu der Identifikationseinheit komplementären Identifikationsmittels, insbesondere DMC-Code, QR-Code, RFID/NFC-Tag oder ähnliches.

Es ergeben sich die diesbezüglich im Vorfeld bereits genannten Vorteile.

Gemäß einer bevorzugten Weiterbildung ist vorgesehen, dass die Spurbreite der Fördereinheit basierend auf der Identifikation der Transportvorrichtung und/oder Werkstücken und/oder Werkstückträgern und/oder Ermittlung der Belegung der Transportvorrichtung mit Werkstücken und/oder Werkstückträgern angepasst wird. Es ergeben sich die diesbezüglich im Vorfeld bereits genannten Vorteile.

Gemäß einer bevorzugten Weiterbildung ist vorgesehen, dass die Werkstücke und/oder Werkstückträger, die in einer an einem ersten Anschlussport angeschlossenen ersten Transportvorrichtung gelagert sind, in eine zweite Transportvorrichtung, die an einem zweiten Anschlussport angeschlossen ist, automatisiert direkt oder mittelbar umgesetzt werden, und/oder dass die Werkstücke und/oder Werkstückträger, die aus einer, an einer ersten Übergabestelle angeschlossenen, ersten Fertigungsanlage entnommen werden, an eine, an einer zweiten Übergabestelle angeschlossene, zweite Fertigungsanlage, automatisiert direkt oder mittelbar übergeben werden. Durch eine Identifikation der in der Transportvorrichtung gelagerten Werkstücke oder Werkstückträger kann eine Spurbreite der Fördereinheit eingestellt werden, so dass verschiedene Werkstücke bzw. Werkstückträger Be- oder Entladen werden können.

Durch ein Umsetzen bzw. Umlagern von Werkstücken zwischen an benachbarten Anschlussports angedockten Transportvorrichtungen kann eine temporäre Zwischenlagermöglichkeit als Pufferspeicher bereitgestellt werden. Auch können Werkstücke oder Werkstückträger durch die Umsetzvorrichtung zwischen zwei, an der Umsetzeinrichtung angeschlossene und benachbarte Fertigungsanlagen umgelagert werden, die somit einen ersten vorgelagerten, und einen zweiten, nachgelagerten Fertigungsschritt durchführen. Auch können z.B. aus zwei parallel angedockten Transportvorrichtungen Werkstücke, die z.B. verbunden werden sollen, entnommen, und in einer Fertigungsanlage zusammengeführt werden, oder aus einer Fertigungsanlage entnommene Werkstücke auf verschiedenen Transportvorrichtungen verteilt werden. Damit kann die Umsetzvorrichtung ein Zusammenführen von Werkstücken aus zwei oder mehreren Transportvorrichtungen bzw. ein Verteilen in zwei oder mehrere Transportvorrichtungen genauso unterstützen, wie ein Zusammenführen aus bzw. Verteilen in zwei oder mehrere Fertigungsanlagen unterstützen. Damit kann die Umsetzvorrichtung als universelles Interface zwischen einer oder mehreren Transportvorrichtungen und einer oder mehreren Fertigungsanlagen dienen, wobei ein temporäreres Puffern für Werkstücken in einer Transportvorrichtung wie ein Ein-, Aus- und Umlagen von Werkstücken in bzw. aus Fertigungsanlagen und Transportvorrichtungen ermöglicht wird.

### ZEICHNUNGEN

Weitere Vorteile ergeben sich aus der vorliegenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- **Fig. 1**: Eine perspektivische Darstellung vorteilhaftes Umsetzsystem mit einer Umsetzvorrichtung und mit einer daran gekoppelten Transportvorrichtung,
- **Fig. 2**: eine perspektivische Darstellung der Transportvorrichtung,
- **Figs. 3A und 3B**: eine Frontalansicht der Umsetzvorrichtung gemäß einem ersten und einem zweiten Ausführungsbeispiel, jeweils mit Blick auf eine im Inneren angeordnete Handhabungseinrichtung,
- **Figs. 4A bis 4B**: jeweils eine Detailansicht auf eine Spanneinrichtung der Umsetzvorrichtung aus verschiedenen Perspektiven,
- **Fig. 5**: Eine vereinfachte Ansicht auf eine Identifikationseinrichtung der Umsetzvorrichtung, und
- **Figs. 6A bis 6C**: jeweils eine perspektivische Darstellung einer Fördereinheit der Handhabungseinrichtung.

In den Figuren sind gleichartige Elemente mit gleichen Bezugszeichen beziffert. Die Figuren zeigen lediglich Beispiele und sind nicht beschränkend zu verstehen.

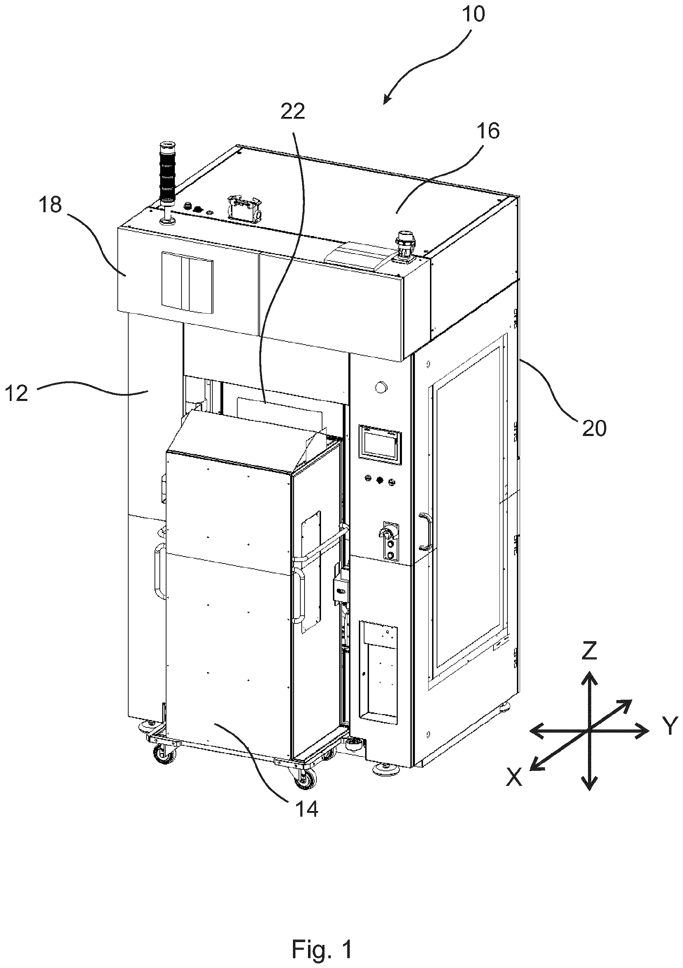

Figur 1 zeigt eine vereinfachte perspektivische Darstellung eines vorteilhaften Umsetzsystems 10. Das Umsetzsystem 10 weist zumindest eine Umsetzvorrichtung 12, zumindest eine Transportvorrichtung 14 und zumindest eine Fertigungsanlage auf, wobei vorliegend in Figur 1 aus Übersichtlichkeitsgründen lediglich eine Umsetzvorrichtung 12 mit einer daran gekoppelten Transportvorrichtung 14 gezeigt und die Fertigungsanlage nicht näher dargestellt ist.

Die Umsetzvorrichtung 12 als zentrales Element des Umsetzsystems 10 ist dazu ausgebildet, vorliegend aus Übersichtlichkeitsgründen nicht weiter dargestellte Werkstücke und/oder Werkstückträger im Rahmen eines Fertigungs- bzw. Handhabungsprozesses zu handhaben. Das Handhaben umfasst unter anderem ein Be- und Entladen der Transportvorrichtung 14 mit den Werkstücken und/oder Werkstückträgern, ein Zwischenspeichern der (zuvor aus der Transportvorrichtung 14 entladenen) Werkstücke und/oder Werkstückträger in der Umsetzvorrichtung 12, sowie ein Umsetzen der Werkstücke und/oder Werkstückträger von der Transportvorrichtung 14 auf die Fertigungsanlage und/oder ein Beladen der Fertigungsanlage mit den (zuvor in der Umsetzvorrichtung 12 zwischengespeicherten) Werkstücken und/oder Werkstückträgern.

Die Umsetzvorrichtung 12 weist ein Gehäuse 16 mit einer Vorderseite 18 und einer der Vorderseite 18 gegenüberliegenden Rückseite 20 auf. In bzw. auf der Vorderseite 18 ist zumindest ein Anschlussport 22 ausgebildet, der zum zumindest temporären Koppeln der Transportvorrichtungen 14 an die Umsetzvorrichtung 12 dient und mittels welchem ein Zugriff der Umsetzvorrichtung 12 auf die in der Transportvorrichtung 14 befindlichen Werkstücke und/oder Werkstückträger zu Handhabungszwecken möglich ist, sodass der besagte Be und Entladeprozess durchgeführt werden kann. Bei der in Figur 1 gezeigten Darstellung ist, wie zuvor bereits erwähnt, die Transportvorrichtung 14 mittels des Anschlussports 22 an die Umsetzvorrichtung 12 gekoppelt.

Die Umsetzvorrichtung 12 weist weiterhin an ihrer Rückseite 20 zumindest eine vorliegend aus Übersichtlichkeitsgründen nicht näher dargestellte Übergabestelle zur Übergabe der Werkstücke und/oder Werkstückträger an die Fertigungsanlage auf. Im Rahmen des bestimmungsgemäßen Gebrauchs der Umsetzvorrichtung 12 bzw. des Umsetzsystems 10 ist insofern die Fertigungsanlage im Zugriffsbereich der Übergabestelle anordenbar oder angeordnet bzw. an die Umsetzvorrichtung 12 koppelbar oder gekoppelt.

Im Rahmen des bestimmungsgemäßen Gebrauchs ist das Umsetzsystem 10 bzw. die Umsetzvorrichtung 12 derart angeordnet bzw. ausgerichtet, dass die Handhabung der Werkstücke und/oder Werkstückträger unter Verwendung eines kartesischen Koordinatensystems beschreibbar ist, wie es in Figur 1 dargestellt ist.

Somit weist die Umsetzvorrichtung 12 eine Umsetzachse X auf, in welche die Vorderseite 18 und die Rückseite 20 ausgerichtet sind. Die Umsetzachse X entspricht insofern der X-Achse des kartesischen Koordinatensystems. Weiterhin weiß die Umsetzvorrichtung 12 eine horizontale Verlagerachse Y auf, die in einer waagrechten Ebene orthogonal zu der Umsetzachse X ausgerichtet ist. Die horizontale Verlagerachse Y entspricht insofern der Y-Achse des kartesischen Koordinatensystems. Des Weiteren weist die Umsetzvorrichtung 12 eine senkrecht bzw. orthogonal zu Umsetzachse X und horizontaler Verlagerachse Y ausgerichtete vertikale Verlagerachse Z auf. Die vertikale Verlagerachse Z entspricht insofern der Z-Achse des kartesischen Koordinatensystems. Im Rahmen des Handhabungsprozesses sind die Werkstücke und/oder Werkstückträger mittels der Umsetzvorrichtung 12 in alle 3 Achsen X, Y, Z verlagerbar, wie an späterer Stelle noch näher erläutert wird.

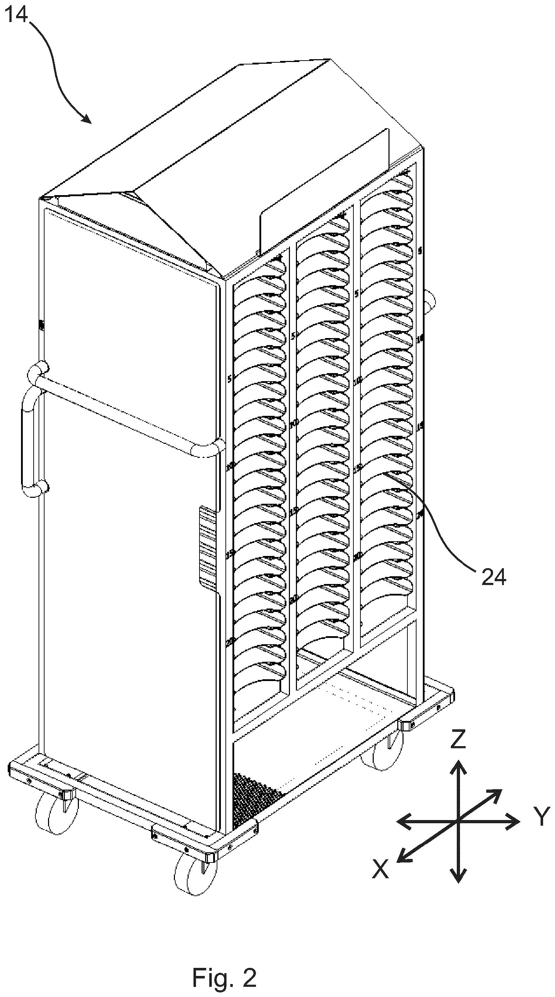

Figur 2 zeigt eine perspektivische Darstellung der zuvor erwähnten Transportvorrichtungen 14. Bei der in Figur 2 gezeigten Darstellung befindet sich die Transportvorrichtung 14 in einem Grundzustand, in welchem sie nicht an die Umsetzvorrichtung 12 bzw. deren Anschlussport 22 gekoppelt ist und sich insofern im entkoppelten Zustand befindet.

Die Transportvorrichtung 14 ist vorliegend als rollbarer Transportwagen ausgebildet, der insofern eine Reihe von Rollen zur Bewegung aufweist. Alternativ kann die Bewegbarkeit der Transportvorrichtung 14 auch durch andere Mittel bereitgestellt werden, beispielsweise eine Schienenführung. Bevorzugt ist die Transportvorrichtung 14 derart ausgebildet, dass sie automatisiert verfahrbar ist. Zusätzlich oder alternativ kann die Transportvorrichtung 14 auch durch Bedienpersonal geschoben werden.

Die Transportvorrichtung 14 weist mehrere Reihen von Ablagefächern 24 auf, in welchen die Werkstücke und/oder Werkstückträger zu Transportzwecken ablegbar bzw. lagerbar sind. Die Transportvorrichtung 14 ist dabei derart ausgebildet, dass zumindest von einer Seite der Transportvorrichtungen 14 ein Zugriff auf die Ablagefächer 24 ermöglicht ist. Größe und Anzahl der Ablagefächer 24 kann in Bezug auf den vorgesehenen bestimmungsgemäßen Gebrauch variieren, sodass entsprechende Transportvorrichtungen 14 des Umsetzsystems 10 verschiedenartig ausgebildete Ablagefächer 24 aufweisen können. Auch können die Ablagefächer 24 einer Transportvorrichtung 14 hinsichtlich ihrer jeweiligen Größe (Höhe, Breite, Tiefe) verstellbar bzw. variabel sein, sodass die Transportvorrichtung einstellbare Ablagefächer 24 und/oder verschiedenartig ausgebildete Ablagefächer 24 aufweisen kann

Die Transportvorrichtung 14 ist derart ausgebildet, dass sie im Rahmen des bestimmungsgemäßen Gebrauchs mit derjenigen Seite, von welcher aus der Zugriff auf die Ablagefächer 24 ermöglicht ist, an den Anschlussport 22 der Umsetzvorrichtung 12 koppelbar ist, wie es beispielsweise bei der in Figur 1 gezeigten Darstellung der Fall ist. Hierdurch kann die Umsetzvorrichtung 12 auf die in den Ablagefächern 24 gelagerten Werkstücke und/oder Werkstückträger zur Durchführung des Handhabungsprozesses zugreifen.

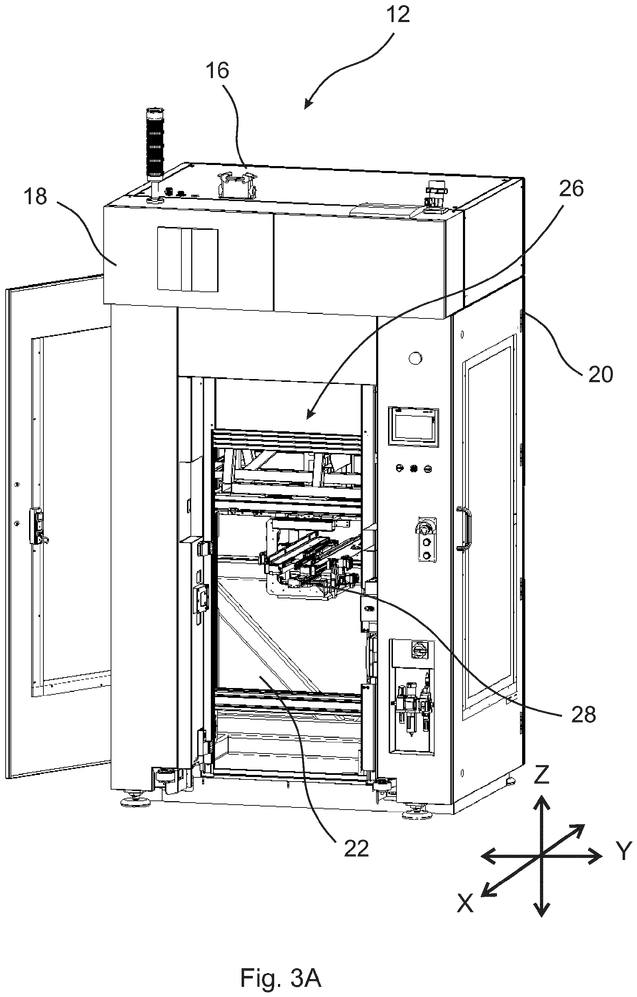

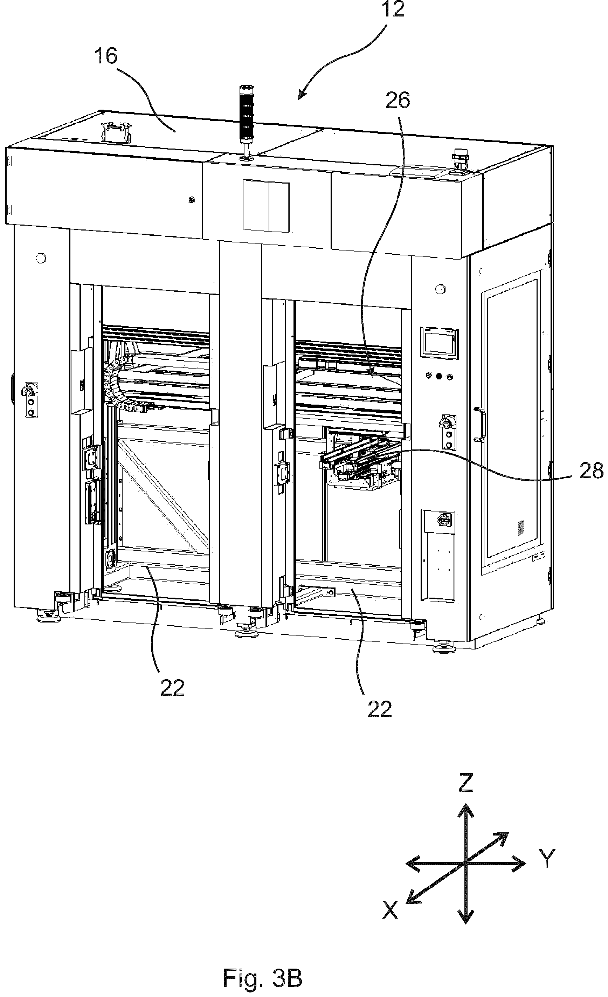

Figuren 3A und 3B zeigen jeweils eine Frontalansicht der Umsetzvorrichtung 12 im entkoppelten Zustand, also in jenem Zustand, an welchem keine Transportvorrichtung 14 an den Anschlussport 22 angekoppelt ist.

Bei dem in Figur 3A gezeigten Ausführungsbeispiel weist die Umsetzvorrichtung 12 einen Anschlussport 22 auf. Bei dem in Figur 3B gezeigten Ausführungsbeispiel hingegen weist die Umsetzvorrichtung 12 zwei Anschlussports 22 für jeweils eine Transportvorrichtungen 14 auf, sodass bei diesem Ausführungsbeispiel zwei Transportvorrichtungen 14 gleichzeitig Be- und Entladen werden können bzw. Werkstücke und/oder Werkstückträger im Zusammenhang mit zwei Transportvorrichtungen 14 handhabbar sind. Ansonsten sind die in den Figuren 3A und 3B gezeigten Ausführungsbeispiele der Umsetzvorrichtung 12 hinsichtlich ihrer weiteren Komponenten und Funktionen identisch, wie im Folgenden näher erörtert wird.

Die Umsetzvorrichtung 12 weist eine im Inneren des Gehäuses 16 angeordnete Handhabungseinrichtung 26 auf, die zur Durchführung des Handhabungsprozesses, also der Handhabung bzw. Verlagerung der Werkstücke und/oder Werkstückträger, ausgebildet ist bzw. dient. Die Handhabungseinrichtung 26 ist derart ausgebildet und im Inneren des Gehäuses 16 angeordnet, dass sowohl der Anschlussport 22, als auch die Übergabestelle im Wirkungsbereich der Handhabungseinrichtung 26 liegen, sodass die Handhabungseinrichtung 26 über den Anschlussport 22 und die Übergabestelle zum Be- und Entladen und/oder Umsetzen der Werkstücke und/oder Werkstückträger auf diese sowie die Transportvorrichtung(en) 14 und die Fertigungsanlage zugreifen kann.

Die Handhabungseinrichtung 26 weist zumindest eine Fördereinheit 28 zum Fördern der Werkstücke und/oder Werkstückträger entlang der Umsetzachse X auf. Mittels der Fördereinheit 28 sind insofern die Werkstücke und/oder Werkstückträger aus den Ablagefächern 24 der an den Anschlussport 22 angekoppelten Transportvorrichtung 14 entnehmbar und in das Innere der Umsetzvorrichtung 12 förderbar sowie von dort aus der Übergabestelle an die Fertigungsanlage weitergebbar oder umgekehrt. Die Fördereinheit 28 ist insofern zum Fördern der Werkstücke und/oder Werkstückträger entlang der Umsetzachse X ausgebildet. Insbesondere kann die Handhabungseinrichtung 26 auch mehrere, bevorzugt gleichartig ausgebildete, Fördereinheiten 28 aufweisen.

Die Handhabungseinrichtung 26 wiederum ist weiterhin dazu ausgebildet, die Fördereinheit 28 sowohl entlang der horizontalen Verlagerachse Y, als auch der vertikalen Verlagerachse Z zu verlagern. Auch eine dreidimensionale rotatorische Ausrichtung der zu handhabenden Werkstücke und/oder Werkstückträger und/oder der Fördereinheit 28 um die drei Achsen X, Y, Z ist möglich. Hierdurch ist die Umsetzvorrichtung 12 dazu in der Lage, mittels der Handhabungseinrichtung 26 die Werkstücke und/oder Werkstückträger im Wesentlichen ungehindert in jegliche Raumrichtung zu fördern bzw. zu verlagern, sodass ein besonders flexibler und effizienter Handhabungsprozesses der Werkstücke und/oder Werkstückträger ermöglicht ist.

Insofern ist die Umsetzvorrichtung 12 insbesondere dazu ausgebildet, mittels der Handhabungseinrichtung 26 und Ihrer Fördereinheit 28 Werkstücke und/oder Werkstückträger von einer an einem ersten Anschlussport 22 gekoppelten ersten Transportvorrichtung 14 auf eine an einen zweiten Anschlussport 22 gekoppelten zweite Transportvorrichtung 14 umzuladen. Auch können mittels der Umsetzvorrichtung 12 in einer oder mehreren Transportvorrichtungen 14 gelagerte Werkstücke und/oder Werkstückträger von diesen Entladen und direkt oder mittelbar (also unter Zwischenlagerung im Inneren des Gehäuses 16) auf die Fertigungsanlage umgesetzt werden. Selbstverständlich ist auch umgekehrt mittels der Umsetzvorrichtung 12 bzw. deren Handhabungseinrichtung 26 eine Aufnahme von aus der Fertigungsanlage kommenden Werkstücken und/oder Werkstückträgern und ein anschließendes Umsetzen bzw. eine Übergabe dieser Werkstücke und/oder Werkstückträger an die Umsetzvorrichtung 12 bzw. an deren Anschlussport(s) 22 gekoppelte Transportvorrichtungen 14, also ein Beladen der Ablagefächer 24 der entsprechenden Transportvorrichtungen 14, möglich.

Um den Koppelvorgang der Transportvorrichtung 14 an den Anschlussport 22 bzw. die Umsetzvorrichtung 12 zu verbessern und hierbei insbesondere ein unproblematisches Be- und Entladen der Werkstücke und/oder Werkstückträger zu ermöglichen, ist bei der vorliegenden Umsetzvorrichtung 12 vorteilhafterweise vorgesehen, dass der Anschlussport 22 eine Spanneinrichtung 30 für die zu koppelnde Transportvorrichtung 14 aufweist. Die Spanneinrichtung 30 ist vorteilhafterweise dazu ausgebildet, zum temporären Koppeln der Transportvorrichtung 14 an den Anschlussport 22 die Transportvorrichtung 14, vorzugsweise automatisiert, an dem Anschlussport 22 lösbar zu arretieren sowie im gekoppelten Zustand ausgerichtet zu zentrieren.

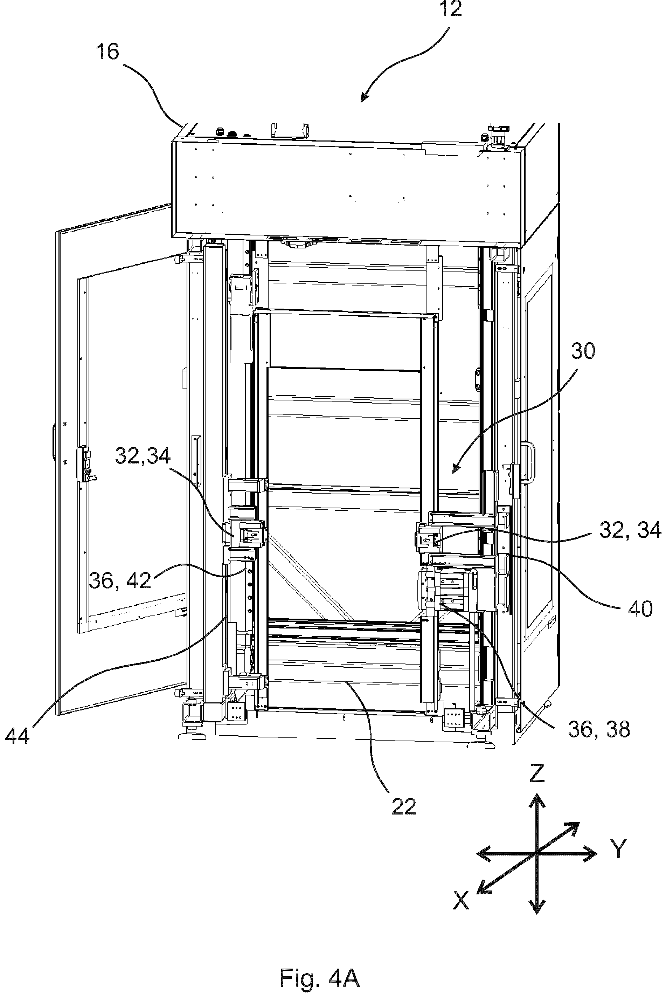

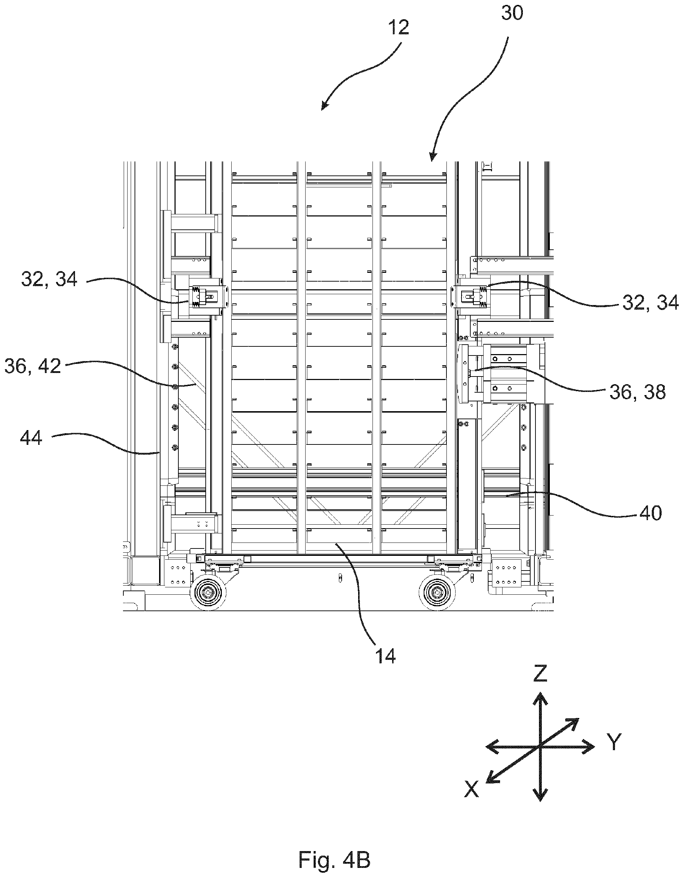

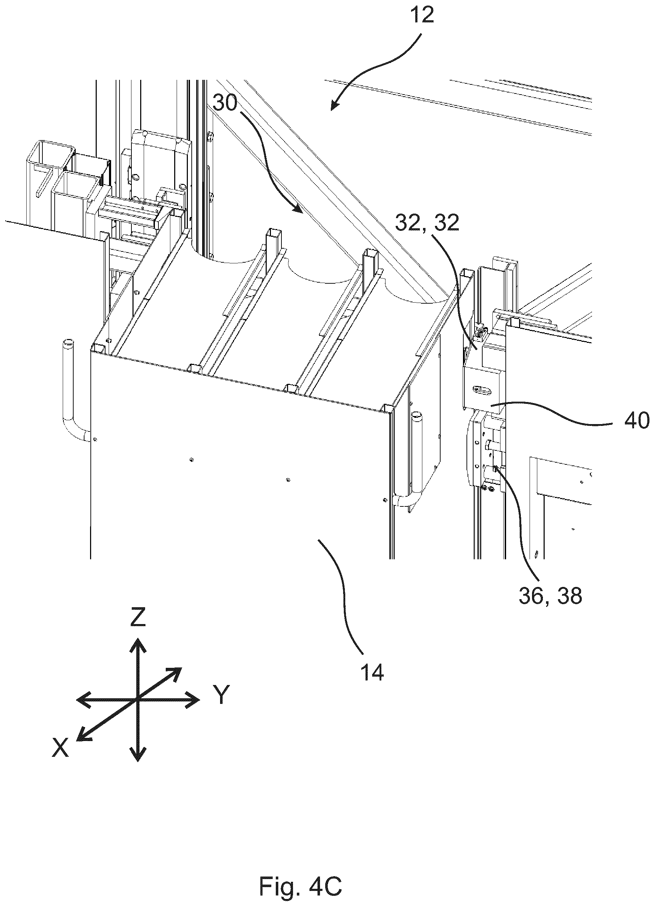

Figuren 4A bis 4C zeigen diesbezüglich eine Detailansicht des Anschlussports 22 mit Blick auf die Spanneinrichtung 30 jeweils aus unterschiedlichen Blickwinkeln. Figur 4A zeigt eine Draufsicht von vorne, Figur 4B eine Draufsicht aus dem Inneren der Umsetzvorrichtung 12 und Figur 4C eine Draufsicht von oben auf eine mittels der Spanneinrichtung 30 gekoppelte Transportvorrichtung 14.

Die Spanneinrichtung 30 weist zur lösbaren Arretierung der Transportvorrichtung 14 eine Rasteinheit 32 mit zumindest zwei federgelagerten Rasthacken 34 auf. Durch die Rasteinheit 32 bzw. deren Rasthacken 34 ist die Transportvorrichtungen 14 bei Anordnung im Wirkungsbereich des Anschlussports 22 bzw. der Spanneinrichtung 30 durch die Rasthacken 34 greifbar und lösbar an dem Anschlussport 22 arretierbar. Insbesondere wird hierbei die Transportvorrichtung 14 durch die Rasthacken 34 an den Anschlussport 22 herangezogen und anschließend in der herangezogenen Position verriegelt.

Des Weiteren weist die Spanneinrichtung 30 zum ausgerichteten Zentrieren der im Vorfeld an dem Anschlussport 22 arretierten bzw. gekoppelten Transportvorrichtung 14 eine Spanneinheit 36 auf. Die Spanneinheit 36 umfasst einen Spannzylinder 38, der in einem ersten Flankenbereich 40 ausgebildet und aus diesem ausfahrbar ist, sowie eine dem Spannzylinder 38 zugeordnete und mit diesem zusammenwirkende Gegendruckfläche 42, die in einem dem ersten Flankenbereich 40 gegenüberliegenden zweiten Flankenbereich 44 ausgebildet ist. Insofern ist der Spannzylinder 38 aus dem ersten Flankenbereich 40 in Richtung der gegenüberliegenden Gegendruckfläche 42 ausfahrbar bzw. verlagerbar. Bei bestimmungsgemäßem Gebrauch wird die an dem Anschlussport 22 mittels der Rasteinheit 32 arretierte Transportvorrichtung 14 durch Ausfahren des Spannzylinders 38 in Richtung der Gegendruckfläche 42 in Bezug auf eine Bodenfläche, auf welche die Umsetzvorrichtung 12 angeordnet ist, zentriert ausgerichtet, bzw. lotrecht positioniert. Im Anschluss wird bei Erreichen der maximalen Ausfahrposition des Spannzylinders 38 die Transportvorrichtung 14 zwischen dem Spannzylinder 38 und der Gegendruckfläche 42 verklemmt bzw. eingespannt und verharrt dadurch in ihrer ausgerichteten Position. Gleichzeitig wird dadurch die bereits mittels der Rasteinheit 32 bereitgestellte Arretierung nochmals durch Verspannen gesichert.

Die Spanneinrichtung 30 ermöglicht insofern vorteilhafterweise ein gleichzeitiges Arretieren sowie Zentrieren der Transportvorrichtungen 14 an dem Anschlussport 22 zur Gewährleistung eines reibungslos funktionalen, insbesondere vollständig automatisierten, Handhabungsprozesses bzw. Umsetzvorgangs der Werkstücke und/oder Werkstückträger.

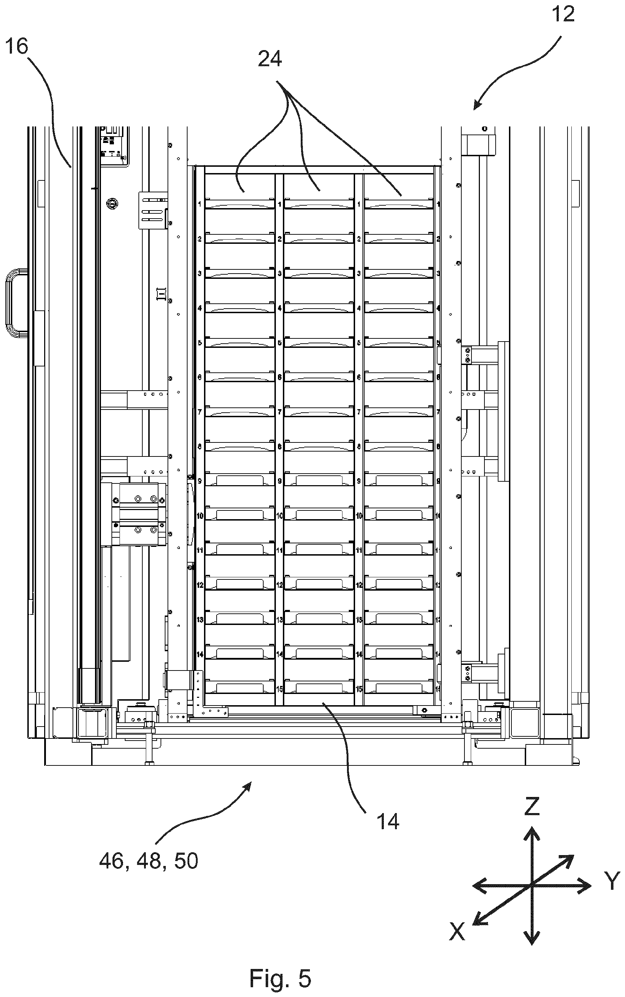

Figur 5 zeigt eine weitere Detaildarstellung der Umsetzvorrichtung 12 im Bereich des Anschlussports 22 mit Blick auf eine an den Anschlussport 22 gekoppelte Transportvorrichtung 14 aus dem Inneren der Transportvorrichtung.

Vorliegend ist vorgesehen, dass die Umsetzvorrichtung 12, insbesondere deren Handhabungseinrichtung 26, eine in Figur 5 aus Übersichtlichkeitsgründen nur angedeutete Identifikationseinrichtung 46 aufweist. Die Identifikationseinrichtung 46 ist dazu ausgebildet, die (an den Anschlussport 22 angekoppelte) Transportvorrichtung 14 sowie generell die zu handhabenden Werkstücke und/oder Werkstückträger zu identifizieren. Hierzu weist die Identifikationseinrichtung 46 zumindest eine Identifikationseinrichtung 48, beispielsweise eine Kamera und/oder Scannereinheit, auf, die in Verbindung mit einem komplementären, auf der Transportvorrichtung 14 und/oder den Werkstücken bzw. Werkstückträgern angeordneten, Identifikationsmittel, beispielsweise QR-Code o.Ä., die Identifikation der Transportvorrichtung 14 bzw. Werkstücke und/oder Werkstückträger ermöglicht. Dies ermöglicht im Rahmen des, bevorzugt automatisierten, Handhabungs- bzw. Umsetzprozess einen reibungslosen Prozessablauf, da zuverlässig sichergestellt werden kann, dass auch die vorgesehene Transportvorrichtung 14 bzw. die vorgesehenen Werkstücke und/oder Werkstückträger verarbeitet werden. Zudem ist anhand der Identifikation gegebenenfalls eine Anpassung der Betriebsparameter der Umsetzvorrichtung 12 möglich, um den Prozess weiter hinsichtlich Geschwindigkeit und Effizienz zu optimieren.

Zusätzlich weist Identifikationseinrichtung 46 vorliegend eine in Figur 5 aus Übersichtlichkeitsgründen ebenfalls angedeutete Sensoreinheit 50 auf, die entlang der horizontalen Verlagerachse Y und vertikalen Verlagerachse Z, bevorzugt rasterförmig, verfahrbar ist. Mittels der Sensoreinheit 50 und/oder der Identifikationseinheit 48 ist die Identifikationseinrichtung 46 weiterhin dazu ausgebildet, automatisiert zu ermitteln, ob die (aktuell an den Anschlussport 22 gekoppelte) Transportvorrichtung 14 bzw. deren Ablagefächer 24 überhaupt mit Werkstücken und/oder Werkstückträgern belegt sind bzw. auf welche Art die Belegung vorliegt. Basierend auf dieser Ermittlung ist die Ansteuerung der Umsetzvorrichtung 12 bzw. deren Handhabungseinrichtung 26 hinsichtlich eines optimierten Handhabungsprozesses anpassbar, sodass insbesondere der Entladevorgang der Werkstücke und/oder Werkstückträger aus den Ablagefächern 24 besonders effizient erfolgt.

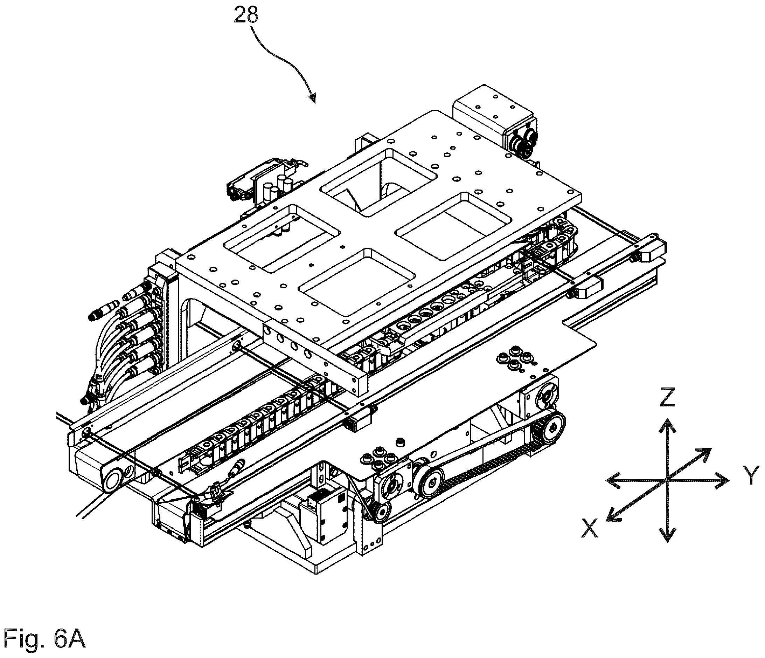

Figuren 6A bis 6 C zeigen jeweils eine detaillierte perspektivische Darstellung der Fördereinheit 28 der Handhabungseinrichtung 26.

Figur 6A zeigt die Fördereinheit 28 beim Fördern eines Werkstücks bzw. Werkstückträgers entlang der Umsetzachse X. Da, wie zuvor bereits erwähnt, dass Umsetzsystem 12 zum Umsetzen bzw. die Umsetzvorrichtung 12 zum Handhaben verschiedenster Werkstücke und/oder Werkstückträger ausgebildet ist, können die Handhabungseinrichtung 26 bzw. die Fördereinheit 28 hinsichtlich ihrer Konfiguration und/oder ihres Betriebs auf die aktuell zu handhabenden Werkstücke und/oder Werkstückträger zumindest bereichsweise angepasst werden.

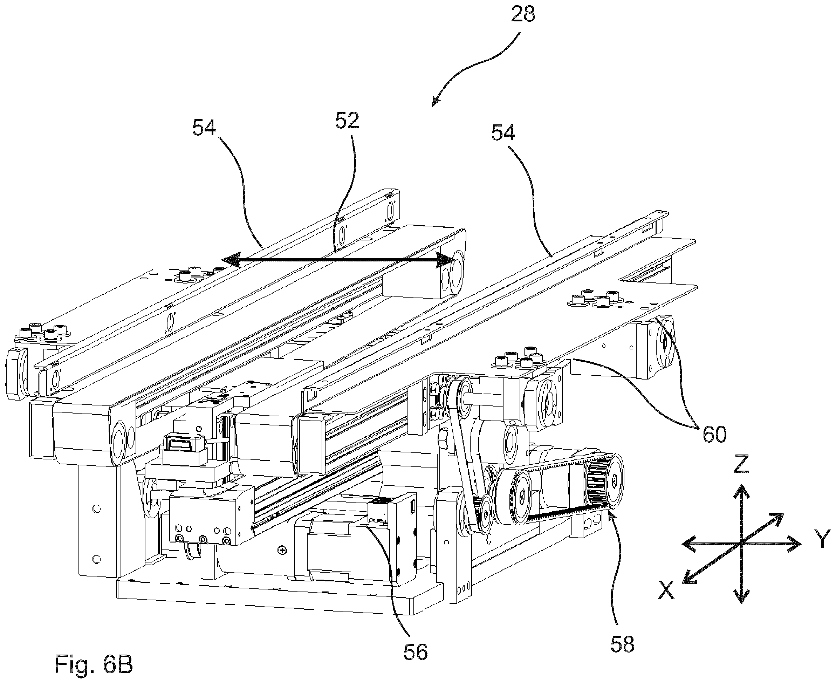

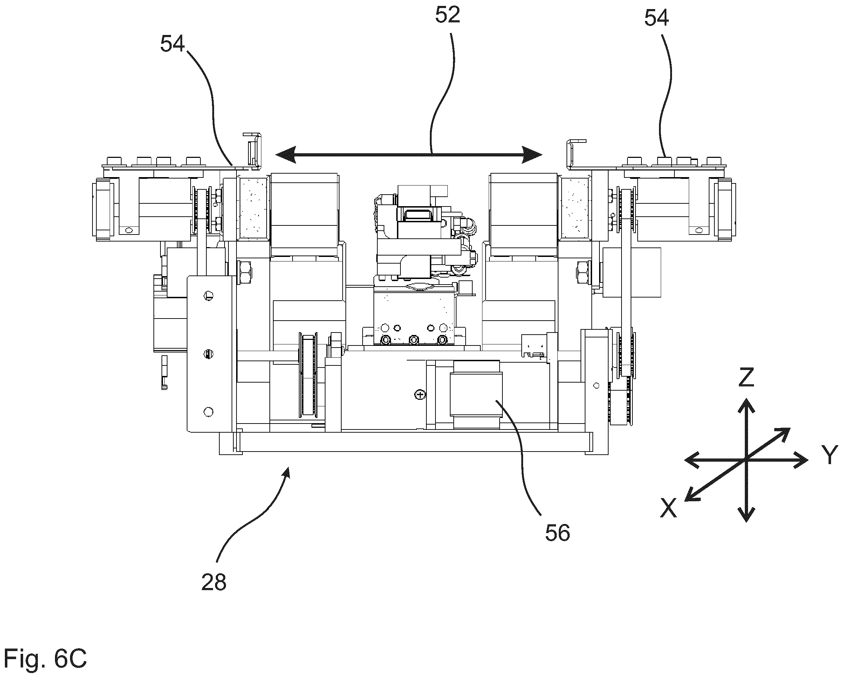

Eine dieser Anpassungsmöglichkeiten ist eine Anpassung einer Spurenbreite 52 der Fördereinheit 28, wie sie in den Figuren 6B und 6C dargestellt ist. Insofern kann die Spurenbreite 52 der Fördereinheit 28 entlang der horizontalen Verlagerachse Y in Bezug auf eine Größe und/oder einen Durchmesser der zu fördernden bzw. zu handhabenden Werkstücke und/oder Werkstückträger, bevorzugt automatisiert, angepasst werden.

Die Anpassung der Spurenbreite 52 erfolgt durch Verlagern von zumindest einem, insbesondere zwei, eine Förderspur entlang der Umsetzachse X bildenden, parallel zueinander verlaufenden Führungsblechen 54 der Fördereinheit 28.

Die Fördereinheit 28 weist einen Antriebsmotor 56, einen Antriebsstrang 58, und ein Getriebe 60, vorliegend Gewindespindeln, auf die funktional derart miteinander gekoppelt sind, dass durch Betreiben des Antriebsmotors 56 und Übertragung der dabei erzeugten Antriebskraft auf die Führungsbleche 54 diese synchron aufeinander zu oder voneinander weg verlagerbar sind. Entsprechend ist insbesondere das Getriebe 60 bzw. die Gewindespindeln derart ausgebildet, dass die Antriebskraft synchron zueinander entgegengesetzt auf die Führungsbleche 54 übertragbar ist, sodass das synchrone aufeinander zu der voneinander wegbewegen ermöglicht ist.

Hierdurch kann die Spurenbreite 52 schnell, flexibel und effizient an die zu handhabenden Werkstücke und/oder Werkstückträger angepasst werden, sodass vorteilhafterweise eine hohe Flexibilität bezüglich der zu handhabenden Werkstücke und/oder Werkstückträger und damit einhergehend eine hohe Einsatzvielfalt des Umsetzsystems 10 bereitgestellt ist.

### Bezugszeichenliste

- 10: Umsetzsystem
- 12: Umsetzvorrichtung
- 14: Transportvorrichtung
- 16: Gehäuse
- 18: Vorderseite
- 20: Rückseite
- 22: Anschlussport
- 24: Ablagefächer
- 26: Handhabungseinrichtung
- 28: Fördereinheit
- 30: Spanneinrichtung
- 32: Rasteinheit
- 34: Rasthacken
- 36: Spanneinheit
- 38: Spannzylinder
- 40: Erster Flankenbereich
- 42: Gegendruckfläche
- 44: Zweiter Flankenbereich
- 46: Identifikationseinrichtung
- 48: Identifikationseinheit
- 50: Sensoreinheit
- 52: Spurbreite
- 54: Führungsblech
- 56: Antriebsmotor
- 58: Antriebsstrang
- 60: Getriebe
- X: Umsetzachse
- Y: Horizontale Verlagerachse
- Z: Vertikale Verlagerachse

## Patentansprüche

1. Umsetzvorrichtung (12) zum Umsetzen von Werkstücken und/oder Werkstückträgern zumindest einer verfahrbaren Transportvorrichtung (14) und/oder zumindest einer Fertigungsanlage, insbesondere zum Be- und Entladen zwischen zumindest einer Transportvorrichtung (14) und zumindest einer Fertigungsanlage, wobei die Umsetzvorrichtung (12) dazu ausgebildet ist, in der zumindest einen Transportvorrichtung (14), insbesondere in einem Rollcontainer, gelagerte Werkstücke und/oder Werkstückträger zu entladen, insbesondere zwischenzulagern, und vorzugsweise in die zumindest eine Fertigungsanlage weiter zu transportieren, und/oder die zumindest eine Transportvorrichtung (14) mit, insbesondere in der Umsetzvorrichtung (12) zwischengelagerten, vorzugsweise aus der zumindest einen Fertigungsanlage entnommenen, Werkstücken und/oder Werkstückträgern zu beladen, wobei die Umsetzvorrichtung (12) ein Gehäuse (16) mit einer in eine Umsetzachse (X) ausgerichteten Vorderseite (18) und einer der Vorderseite (18) gegenüberliegenden Rückseite (20) aufweist, wobei die Vorderseite (18) zumindest einen Anschlussport (22) zum temporären Koppeln der zumindest einen Transportvorrichtung (14) umfasst, und die Rückseite (20) eine an die Fertigungsanalage anschließbare Übergabestelle zur Übergabe von Werkstücken und/oder Werkstückträgern an die zumindest eine Fertigungsanlage umfasst, **dadurch gekennzeichnet, dass** der Anschlussport (22) eine Spanneinrichtung (30) für die Transportvorrichtung (14) aufweist, die ausgebildet ist, die Transportvorrichtung (14) zum temporären Koppeln an den Anschlussport (22), bevorzugt automatisiert, an dem Anschlussport (22) zu arretieren sowie im gekoppelten Zustand ausgerichtet zu zentrieren, insbesondere in Bezug auf eine Bezugsebene, insbesondere Bodenfläche, auf welcher die Umsetzvorrichtung (12) angeordnet ist, auszurichten.

2. Umsetzvorrichtung nach Anspruch 1, **dadurch gekennzeichnet, dass** die Spanneinrichtung (30) eine Rasteinheit (32) mit zumindest einem, vorzugsweise zumindest zwei, federgelagerten Rasthacken (34) sowie eine hydraulische und/oder pneumatische Spanneinheit (36) umfasst, wobei die Rasteinheit (32) dazu ausgebildet ist, durch Einrasten der Transportvorrichtung (14) diese an dem Anschlussport (22) lösbar zu arretieren, und wobei die Spanneinheit (36) dazu ausgebildet ist, die arretierte Transportvorrichtung (14) durch Verspannen in dem Anschlussport (22) ausgerichtet zu zentrieren.

3. Umsetzvorrichtung nach Anspruch 2, **dadurch gekennzeichnet, dass** die Spanneinheit (36) zumindest einen Spannzylinder (38) und eine dem Spannzylinder (38) zugeordnete Gegendruckfläche (42) umfasst, wobei der Spannzylinder (38) aus einem ersten Flankenbereich (40) des Anschlussports (22) in Richtung eines dem ersten Flankenbereich (40) gegenüberliegenden zweiten Flankenbereich (44), in welchem die Gegendruckfläche (42) ausgebildet ist, ausfahrbar ist, sodass die arretierte Transportvorrichtung (14) durch Ausfahren des Spannzylinder (38) in Richtung der Gegendruckfläche (42) einspannbar und ausgerichtet zentrierbar ist.

4. Umsetzvorrichtung nach einem der vorhergehenden Ansprüche, **dadurch gekennzeichnet, dass** die Umsetzvorrichtung (12) eine im Inneren des Gehäuses (16) angeordnete Handhabungseinrichtung (26) zum Handhaben der Werkstücke und/oder Werkstückträger aufweist, wobei die Handhabungseinrichtung (26) zumindest eine Fördereinheit (28) zum Fördern der Werkstücke und/oder Werkstückträger in die Umsetzachse (X) aufweist.

5. Umsetzvorrichtung nach Anspruch 4, **dadurch gekennzeichnet, dass** eine Spurbreite (52) der Fördereinheit (28) in einer horizontalen Verlagerachse (Y) in Bezug auf eine Größe oder einen Durchmesser der zu fördernden Werkstücke und/oder Werkstückträger, insbesondere automatisiert, anpassbar ist.

6. Umsetzvorrichtung nach Anspruch 5, **dadurch gekennzeichnet, dass** die Spurbreite (52) durch Verlagern von zumindest einem, insbesondere zwei, eine Förderspur entlang der Umsetzachse (X) bildende, und parallel zueinander verlaufenden Führungsblechen (54) der Fördereinheit (28) anpassbar ist, wobei vorzugsweise die Führungsbleche (54) durch einen Antriebsmotor (56) verlagerbar sind, der mittels eines Getriebes (60), insbesondere Gewindespindeln, derart mit den Führungsblechen (54) gekoppelt ist, dass diese synchron aufeinander zu oder voneinander weg verlagerbar sind.

7. Umsetzvorrichtung nach einem der Ansprüche 4 bis 6, **dadurch gekennzeichnet, dass** die Handhabungseinrichtung (26) dazu ausgebildet ist, die Fördereinheit (28) zumindest entlang einer horizontalen (Y) und/oder vertikalen Verlagerachse (Z) orthogonal zur Umsetzachse (X) zu verlagern, und/oder zu handhabende Werkstücke und/oder Werkstückträger und/oder die Fördereinheit (28) um zumindest eine Verlagerachse (Y, Z) und/oder um die Umsetzachse (X), vorzugsweise dreidimensional, rotatorisch auszurichten.

8. Umsetzvorrichtung nach einem der vorhergehenden Ansprüche, **dadurch gekennzeichnet, dass** die Umsetzvorrichtung (12), vorzugsweise die Handhabungseinrichtung (26), zumindest eine Identifikationseinrichtung (46) zur automatisierten Identifikation der Transportvorrichtung (14) und/oder der Werkstücke und/oder der Werkstückträger, und/oder zur automatisierten Ermittlung einer Belegung der Transportvorrichtung (14) mit Werkstücken und/oder Werkstückträgern aufweist, insbesondere zumindest eine erste Identifikationseinrichtung (46) zur Identifikation zur Identifikation der Transportvorrichtung (14) und zumindest eine zweite Identifikationseinrichtung (46) z der Werkstücke und/oder der Werkstückträger aufweist.

9. Umsetzvorrichtung nach Anspruch 8, **dadurch gekennzeichnet, dass** die zumindest eine Identifikationseinrichtung (46) eine entlang zumindest einer Verlagerachse (Y, Z), insbesondere rasterförmig, verfahrbare Sensoreinheit (50) aufweist, die dazu ausgebildet ist, im gekoppelten Zustand der Transportvorrichtung (14) eine Belegung der Transportvorrichtung (14) mit Werkstücken und/oder Werkstückträgern zu ermitteln, und/oder in der Transportvorrichtung (14) gelagerte Werkstücke und/oder Werkstückträger zu identifizieren

10. Umsetzvorrichtung nach Anspruch 8 oder 9, **dadurch gekennzeichnet, dass** die Identifikationseinrichtung (46) eine Identifikationseinheit (48), insbesondere Kamera, Code-Scanner und/oder Transponder, aufweist, welche dazu ausgebildet ist, die Transportvorrichtung (14), insbesondere im gekoppelten Zustand, zu identifizieren, insbesondere anhand eines zu der Identifikationseinheit (48) komplementären Identifikationsmittels, insbesondere Barcode, DMC-Code, QR-Code, RFID/NFC-Tag oder dergleichen.

11. Umsetzvorrichtung nach einem der vorhergehenden Ansprüche, **dadurch gekennzeichnet, dass** die Umsetzvorrichtung (12) an der Vorderseite (18) zwei oder mehrere nebeneinander angeordnete Anschlussports (22) für jeweils eine weitere Transportvorrichtung (14) aufweist.

12. Umsetzvorrichtung nach einem der vorhergehenden Ansprüche, **dadurch gekennzeichnet, dass** die Umsetzvorrichtung (12) an der Rückseite (20) zwei oder mehrere nebeneinander angeordnete Übergabestellen zur Übergabe von Werkstücken und/oder Werkstückträgern an zwei oder mehrere Fertigungsanlagen aufweist.

13. Umsetzvorrichtung nach Anspruch 11 oder 12, **dadurch gekennzeichnet, dass** die Umsetzvorrichtung (12) dazu ausgebildet ist, Werkstücke und/oder Werkstückträger, die in einer an einem ersten Anschlussport (22) angeschlossenen ersten Transportvorrichtung (14) gelagert sind, in eine zweite Transportvorrichtung (14), die an einem zweiten Anschlussport (22) angeschlossen ist, automatisiert direkt oder mittelbar umzusetzen, und/oder dass die Umsetzvorrichtung (12) dazu ausgebildet ist, Werkstücke und/oder Werkstückträger, die einer, an einer ersten Übergabestelle angeschlossenen, ersten Fertigungsanlage entnehmbar sind, an eine, an einer zweiten Übergabestelle angeschlossenen, zweiten Fertigungsanlage, automatisiert direkt oder mittelbar zu übergeben.

14. Umsetzvorrichtung nach einem der vorhergehenden Ansprüche, **dadurch gekennzeichnet, dass** die Umsetzvorrichtung (12) eine, insbesondere in dem Gehäuse (16) angeordnete, Steuereinheit aufweist, die dazu ausgebildet ist, die Umsetzvorrichtung (12) zumindest zum automatisierten Be- und Entladen der Transportvorrichtung (14) mit Werkstücken und/oder Werkstückträgern sowie zum automatisierten Umsetzen der Werkstücke und/oder Werkstückträger von der Transportvorrichtung (14) oder aus der Umsetzvorrichtung (12) in die die Fertigungsanalage und umgekehrt zu steuern, wobei die Steuereinheit vorzugsweise eine Schnittstelle zur Kommunikation mit einer Steuereinheit der Fertigungsanlage aufweist, insbesondere eine Industriebus-Kommunikationsschnittstelle aufweist.

15. Umsetzsystem (10) zum Be- und Entladen sowie Umsetzen von Werkstücken und/oder Werkstückträgern, zumindest aufweisend zumindest eine verfahrbare Transportvorrichtung (14) zum temporären Lagern und Transportieren von Werkstücken und/oder Werkstückträgern, zumindest eine Fertigungsanalage zum Weiterverarbeiten der Werkstücke und/oder Werkstückträger in einem Fertigungsprozess, und zumindest eine Umsetzvorrichtung (12) zum Umsetzen von Werkstücken und/oder Werkstückträgern der Transportvorrichtung (14) und/oder der Fertigungsanlage, insbesondere zum Be- und Entladen sowie Umsetzen zwischen Transportvorrichtung (14) und Fertigungsanlage, **gekennzeichnet durch** eine Ausbildung der Umsetzvorrichtung (12) nach einem der vorhergehenden Ansprüche.

16. Verfahren zum Betreiben einer Umsetzvorrichtung, insbesondere Umsetzvorrichtung (12) nach einem der Ansprüche 1 bis 14, und/oder eines Umsetzsystems, insbesondere Umsetzsystem (10) nach Anspruch 15, wobei Werkstücke und/oder Werkstückträger zumindest einer verfahrbaren Transportvorrichtung (14) und/oder zumindest einer Fertigungsanlage umgesetzt werden, insbesondere zwischen Transportvorrichtung (14) und Fertigungsanlage Be- und entladen sowie umgesetzt werden, **dadurch gekennzeichnet, dass** die Transportvorrichtung (14) zum temporären Koppeln an einen Anschlussport (22) der Umsetzvorrichtung durch eine Spanneinrichtung (30) der Umsetzvorrichtung (12), bevorzugt automatisiert, lösbar an dem Anschlussport (22) arretiert und im angeschlossenen Zustand durch die Spanneinrichtung (30) ausgerichtet zentriert wird, insbesondere in Bezug auf eine Bezugsebene, insbesondere Bodenfläche, auf welcher die Umsetzvorrichtung (12) angeordnet ist, ausgerichtet wird.

17. Verfahren nach Anspruch 16, **dadurch gekennzeichnet, dass** die Transportvorrichtung (14) durch eine Rasteinheit (32) der Spanneinrichtung (30) lösbar an dem Anschlussport (22) arretiert wird und im arretierten Zustand durch eine hydraulische und/oder pneumatische Spanneinheit (36) der Spanneinrichtung (30) durch Verspannen in dem Anschlussport (22) ausgerichtet zentriert wird, vorzugsweise indem ein Spannzylinder (38) der Spanneinheit (36) in Richtung eines einem ersten Flankenbereich (40) des Anschlussport (22)s gegenüberliegenden zweiten Flankenbereich (44), in welchem eine Gegendruckfläche (42) für den Spannzylinder (38) ausgebildet ist, ausgefahren wird, sodass die arretierte Transportvorrichtung (14) durch Ausfahren des Spannzylinders (38) in Richtung der Gegendruckfläche (42) eingespannt und ausgerichtet zentriert wird, wobei vorzugsweise eine Sicherheitseinrichtung einen Zugang eines Anschlussports (22) basierend auf einer erfolgreichen Arretierung und/oder Identifikation der Transportvorrichtung (14) bereitstellt.

18. Verfahren nach Anspruch 16 oder 17, **dadurch gekennzeichnet, dass** das Umsetzen der Werkstücke und/oder Werkstückträger durch eine Handhabungseinrichtung (26), die eine Fördereinheit (28) zum Fördern der Werkstücke und/oder Werkstückträger in Richtung einer Umsetzachse (X) aufweist, gehandhabt werden, wobei eine Spurbreite (52) der Fördereinheit (28) in Bezug auf eine Größe oder einen Durchmesser der zu handhabenden Werkstücke und/oder Werkstückträger, bevorzugt automatisiert, angepasst wird, wobei vorzugsweise zur Anpassung der Spurbreite (52) zumindest zwei, die Spur bildendende und parallel zueinander verlaufende, Führungsbleche (54) der Fördereinheit (28) durch einen Antriebsmotor (56) verlagert werden.

19. Verfahren nach einem der Ansprüche 16 bis 18, **dadurch gekennzeichnet, dass** durch eine Identifikationseinrichtung (46) der Umsetzvorrichtung (12) die Transportvorrichtung (14) und/oder Werkstücke und/oder Werkstückträger automatisiert identifiziert und/oder eine Belegung der Transportvorrichtung (14) mit Werkstücken und/oder Werkstückträgern automatisiert ermittelt wird, wobei vorzugsweise
- im angeschlossenen Zustand der Transportvorrichtung (14) die Ermittlung der Belegung der Transportvorrichtung (14) mit Werkstücken und/oder Werkstückträgern und/oder die Identifikation der in der Transportvorrichtung (14) gelagerten Werkstücke und/oder Werkstückträger durch eine entlang zumindest einer Verlagerachse, insbesondere rasterförmig, verfahrbare Sensoreinheit (50) erfolgt,
- und/oder die Identifikation der Transportvorrichtung (14) durch eine Identifikationseinheit (48), insbesondere Kamera, Code-Scanner und/oder Transponder, erfolgt, insbesondere anhand eines zu der Identifikationseinheit (48) komplementären Identifikationsmittels, insbesondere DMC-Code, QR-Code, RFID/NFC-Tag oder ähnliches.

20. Verfahren nach den Ansprüchen 18 und 19, **dadurch gekennzeichnet, dass** die Spurbreite (52) der Fördereinheit (28) basierend auf der Identifikation der Transportvorrichtung (14) und/oder Werkstücken und/oder Werkstückträgern und/oder Ermittlung der Belegung der Transportvorrichtung (14) mit Werkstücken und/oder Werkstückträgern angepasst wird.

21. Verfahren nach einem der Ansprüche 16 bis 20, **dadurch gekennzeichnet, dass** die Werkstücke und/oder Werkstückträger, die in einer an einem ersten Anschlussport (22) angeschlossenen ersten Transportvorrichtung (14) gelagert sind, in eine zweite Transportvorrichtung (14), die an einem zweiten Anschlussport (22) angeschlossen ist, automatisiert direkt oder mittelbar umgesetzt werden, und/oder dass die Werkstücke und/oder Werkstückträger, die aus einer, an einer ersten Übergabestelle angeschlossenen, ersten Fertigungsanlage entnommen werden, an eine, an einer zweiten Übergabestelle angeschlossene, zweite Fertigungsanlage, automatisiert direkt oder mittelbar übergeben werden.
